# EUROPEAN PATENT APPLICATION

(11) **EP 4 756 813 A1**
(43) Date of publication of application: **10.06.2026**
(21) Application number: 25211183.6
(22) Date of filing: 24.10.2025
(51) Int. Cl.: G11C 29/00, G11C 5/02, G11C 16/04

(54) **NONVOLATILE MEMORY DEVICE PERFORMING COLUMN REPAIR**

(30) Priority: 05.12.2024 KR 20240179131
(71) Applicant: Samsung Electronics Co., Ltd., Suwon-si, Gyeonggi-do 16677 (KR)
(72) Inventor: PARK, Jiyoon, 16677 Suwon-si (KR); FUTATSUYAMA, Takuya, 16677 Suwon-si (KR)
(74) Representative: Marks & Clerk LLP

(57) **Abstract**

A nonvolatile memory device includes a first cell region, a second cell region and a peripheral circuit region. The first cell region includes first normal bitlines and first redundant bitlines. The second cell region is disposed in a vertical direction above the first cell region and includes second normal bitlines and second redundant bitlines. The peripheral circuit region is disposed in the vertical direction below the first cell region and includes a page buffer circuit and a page buffer decoder. The page buffer circuit includes page buffers connected to the first normal bitlines, the second normal bitlines, the first redundant bitlines and the second redundant bitlines. The page buffer decoder is configured to integrate defective bitlines occurring among the first normal bitlines and the second normal bitlines and replace the defective bitlines with the first redundant bitlines and the second redundant bitlines.

## Description

### BACKGROUND

A semiconductor memory device may include a large number of memory cells for storing data. If at least one of the memory cells becomes defective during mass production of the memory device, the yield of the memory device may be improved by performing a repair on the defective cell. To repair the defective cell, the memory device may have a redundant memory cell in a spare area and replace the defective cell with the redundant memory cell.

### SUMMARY

Some aspects of this disclosure provide nonvolatile memory devices capable of efficiently performing a column repair.

According to some implementations of the present disclosure, a nonvolatile memory device includes a first cell region, a second cell region and a peripheral circuit region. The first cell region includes a plurality of first normal bitlines and a plurality of first redundant bitlines. The second cell region is disposed in a vertical direction above the first cell region and includes a plurality of second normal bitlines and a plurality of second redundant bitlines. The peripheral circuit region is disposed in the vertical direction below the first cell region and includes a page buffer circuit and a page buffer decoder. The page buffer circuit includes a plurality of page buffers connected to the plurality of first normal bitlines, the plurality of second normal bitlines, the plurality of first redundant bitlines and the plurality of second redundant bitlines. The page buffer decoder is configured to integrate defective bitlines occurring among the plurality of first normal bitlines and the plurality of second normal bitlines and replace the defective bitlines with the plurality of first redundant bitlines and the plurality of second redundant bitlines.

According to some implementations of the present disclosure, a nonvolatile memory device includes a first cell region including a plurality of first normal bitlines and a plurality of first redundant bitlines, a second cell region disposed in a vertical direction above the first cell region and including a plurality of second normal bitlines and a plurality of second redundant bitlines, and a peripheral circuit region including a page buffer circuit and a page buffer decoder. The page buffer circuit includes a plurality of page buffers connected to the plurality of first normal bitlines, the plurality of second normal bitlines, the plurality of first redundant bitlines and the plurality of second redundant bitlines. The page buffer decoder is configured to integrate defective bitlines occurring among the plurality of first normal bitlines and the plurality of second normal bitlines and replace the defective bitlines with the plurality of first redundant bitlines and the plurality of second redundant bitlines.

According to some implementations of the present disclosure, a nonvolatile memory device includes a plurality of cell regions and a peripheral circuit region stacked in a vertical direction. Each cell region of the plurality of cell regions includes a plurality of normal bitlines and a plurality of redundant bitlines. The peripheral circuit region includes a page buffer decoder configured to replace at least some of the defective bitlines occurring among a plurality of normal bitlines included in one cell region of the plurality of cell regions with redundant bitlines included in another cell region of the plurality of cell regions.

Accordingly, some implementations of the nonvolatile memory devices described herein may provide improved repair performance and yield, e.g., by performing column repair with integrating defective bitlines that occur among a plurality of cell regions, in comparison with a nonvolatile memory device lacking the features described herein. In addition, in some implementations, the nonvolatile memory device may reduce repair resources and the size of the nonvolatile memory device in comparison with a nonvolatile memory device lacking the features described herein.

At least some of the above and other features of the invention are set out in the claims.

### BRIEF DESCRIPTION OF THE DRAWINGS

FIG. 1 is a perspective diagram illustrating an example of a nonvolatile memory device.
FIG. 2 is a diagram illustrating an example of a layout of a page buffer circuit and a page buffer decoder included in a nonvolatile memory device.
FIGS. 3 and 4 are diagrams illustrating examples of integrated column repair of a nonvolatile memory device.
FIG. 5 is a diagram illustrating an example of a layout of a page buffer circuit and a page buffer decoder included in a nonvolatile memory device.
FIG. 6 is a diagram illustrating an example of column repair information of a nonvolatile memory device.
FIG. 7 is a timing diagram illustrating an example of operation of the page buffer decoder of FIG. 5, corresponding to the column repair information of FIG. 6.
FIG. 8 is a block diagram illustrating an example of a storage device.
FIG. 9 is a block diagram illustrating an example of a memory controller included in a storage device.
FIG. 10 is a block diagram illustrating an example of a nonvolatile memory device.
FIG. 11 is a block diagram illustrating an example of a storage device.
FIG. 12 is a block diagram illustrating an example of a memory cell array included in a nonvolatile memory device.
FIG. 13 is a circuit diagram illustrating an equivalent circuit of an example of a memory block included in a memory cell array.
FIGS. 14 and 15 are diagrams illustrating examples of connections of bitlines and page buffers of a nonvolatile memory device.
FIG. 16 is a cross-sectional diagram illustrating an example of a vertical structure of a nonvolatile memory device.
FIG. 17 is a diagram illustrating an example of an intersection region of bitlines and input-output contacts of a nonvolatile memory device.
FIG. 18 is a circuit diagram illustrating an example of a page buffer included in a nonvolatile memory device.
FIGS. 19 and 20 are diagrams illustrating examples of a double drive wordline (DDWL) structure of a nonvolatile memory device.
FIG. 21 is a diagram illustrating an example of a configuration corresponding to the DDWL structure of FIG. 20.
FIG. 22 is a diagram illustrating an example of a pass transistor circuit.
FIG. 23 is a perspective diagram illustrating an example of a nonvolatile memory device.
FIG. 24 is a diagram illustrating an example of integrated column repair of the nonvolatile memory device of FIG. 23.
FIG. 25 is a block diagram illustrating an example of a page buffer circuit and a page buffer decoder included in the nonvolatile memory device of FIG. 23.
FIG. 26 is a perspective diagram illustrating an example of a nonvolatile memory device.
FIG. 27 is a block diagram illustrating an example of a data center including a storage device.
FIG. 28 is a cross-sectional diagram illustrating an example of a nonvolatile memory device.
FIG. 29 is a diagram illustrating examples of manufacturing processes of a nonvolatile memory device.
FIG. 30 is a cross-sectional diagram illustrating an example of a semiconductor package including a nonvolatile memory device.

### DETAILED DESCRIPTION

In the drawings, like numerals refer to like elements throughout, and repeated descriptions may be omitted.

Hereinafter, two directions that are parallel to an upper surface of a semiconductor substrate and intersect each other are defined as a first direction D1 and a second direction D2, respectively, and the direction that is substantially perpendicular to the upper surface of the semiconductor substrate is defined as a third direction D3. For example, the first direction D1 and the second direction D2 may intersect each other substantially perpendicularly. The first direction D1 may be referred to as a first horizontal direction or a row direction, the second direction D2 may be referred to as a second horizontal direction or a column direction, and the third direction D3 may be referred to as a vertical direction. The direction indicated by an arrow in the drawing and its opposite direction are described as the same direction. The definition of the above-mentioned directions may be the same in all drawings thereafter.

During a repair to a defective cell, according to a column repair, a column line (e.g., a bitline) associated with the defective cell may be replaced with a column line associated with the redundant memory cell, i.e., a column repair may be performed by mapping (or translating) a column address corresponding to a column line associated with the defective cell to a column address corresponding to a column line associated with the redundant memory cell. As the number of redundant memory cells and redundant bitlines for column repair increases, the chip area of the memory device may increase.

Some aspects of the present disclosure provide increased efficiency of column repair operations.

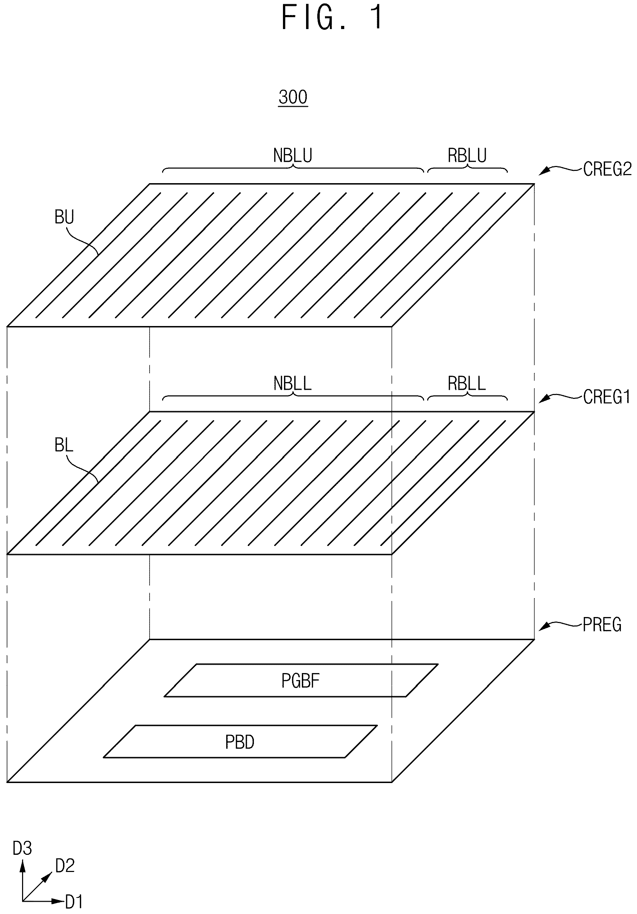

FIG. 1 is a perspective diagram illustrating an example of a nonvolatile memory device. Referring to FIG. 1, a nonvolatile memory device 300 may include a first cell region CREG1, a second cell region CREG2, and a peripheral circuit region PREG. In some implementations, the first cell region CREG1, the second cell region CREG2, and the peripheral circuit region PREG may be stacked in a vertical direction D3. For example, as shown in FIG. 1, the second cell region CREG2 may be disposed above the first cell region CREG1 in the vertical direction D3, and the peripheral circuit region PREG may be disposed below the first cell region CREG1 in the vertical direction D3.

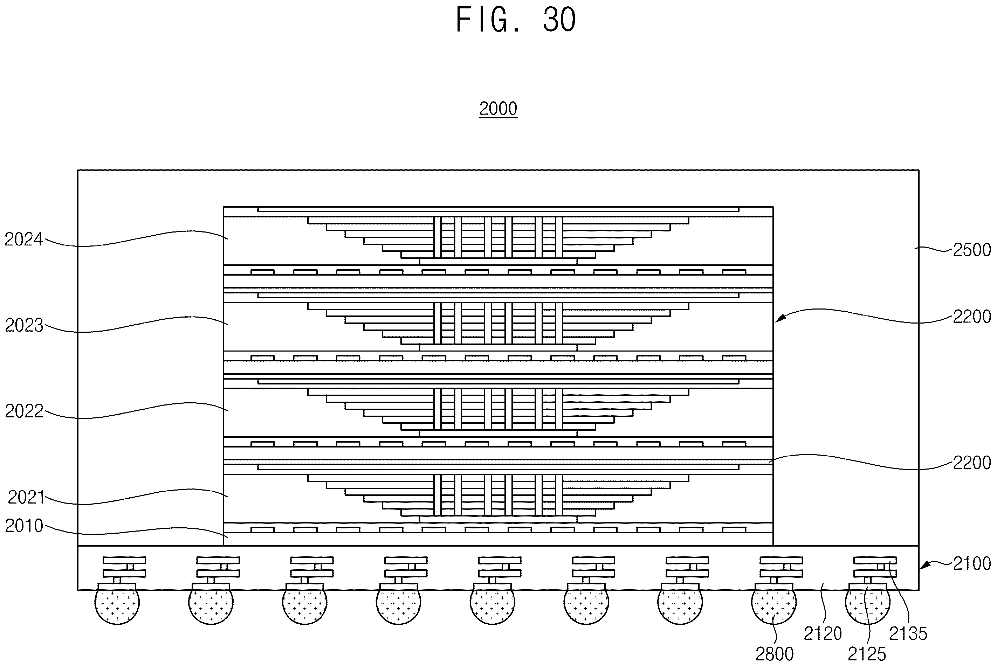

For convenience of illustration and description, the case of stacking two cell regions CREG1 and CREG2 in the vertical direction D3 will be described, but device structures within the scope of this disclosure are not limited thereto. For example, as described with reference to FIG. 30, a nonvolatile memory device may include three or more stacked cell regions, and may apply an integrated column repair with respect to all of the vertically stacked cell regions. One or more cell regions may be interposed between the peripheral circuit region PREG and the first cell region CREG1, and/or one or more cell regions may be interposed between the first cell region CREG1 and the second cell region CREG2.

The first cell region CREG1 may include a plurality of first bitlines BL, and the second cell region CREG2 may include a plurality of second bitlines BU. The first bitlines BL of the first cell region CREG1 may include a plurality of first normal bitlines NBLL and a plurality of first redundant bitlines RBLL. The second bitlines BU of the second cell region CREG2 may include a plurality of second normal bitlines NBLU and a plurality of second redundant bitlines RBLU.

The plurality of first normal bitlines NBLL, the plurality of first redundant bitlines RBLL, the plurality of second normal bitlines NBLU, and the plurality of second redundant bitlines RBLU may be arranged in a first horizontal direction D1 (e.g., spaced apart from one another in the first horizontal direction D1) and extend in a second horizontal direction D2 perpendicular to the first horizontal direction D1.

The peripheral circuit region PREG may include a page buffer circuit PGBF and a page buffer decoder PBD.

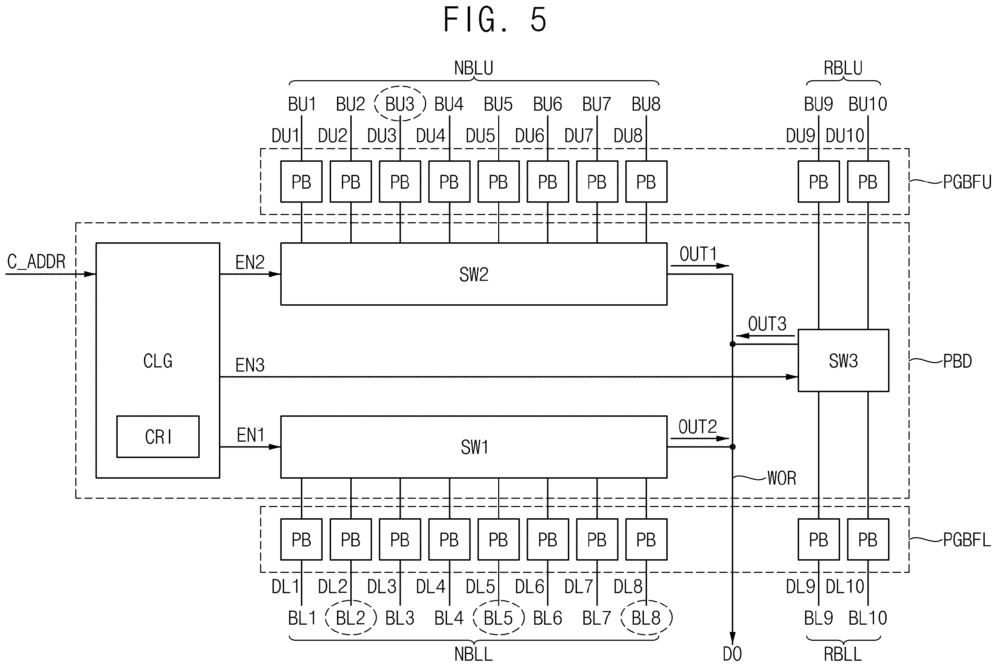

The page buffer circuit PGBF may include a plurality of page buffers connected to the plurality of first normal bitlines NBLL, the plurality of second normal bitlines NBLU, the plurality of first redundant bitlines RBLL, and the plurality of second redundant bitlines RBLU. As will be described below with reference to FIGS. 5, 14, and 15, one bitline and one page buffer may be connected one-to-one.

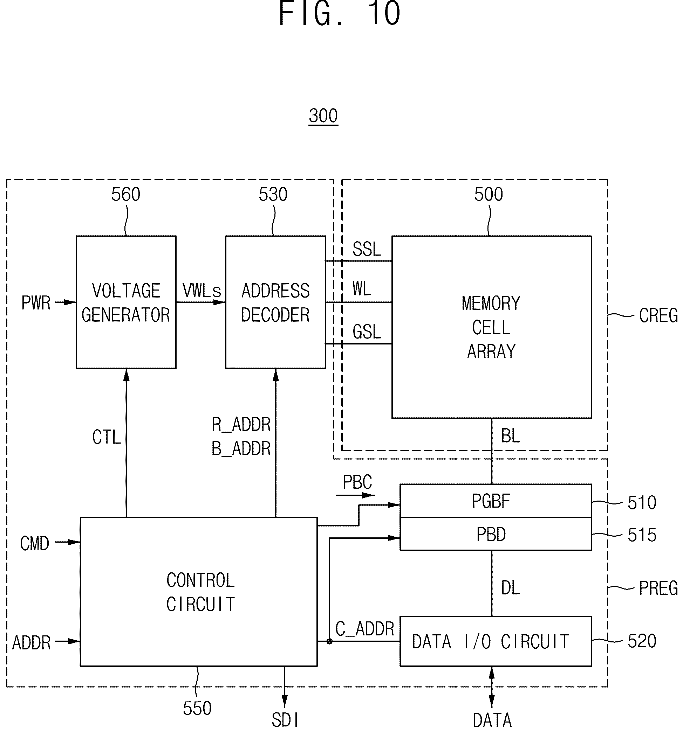

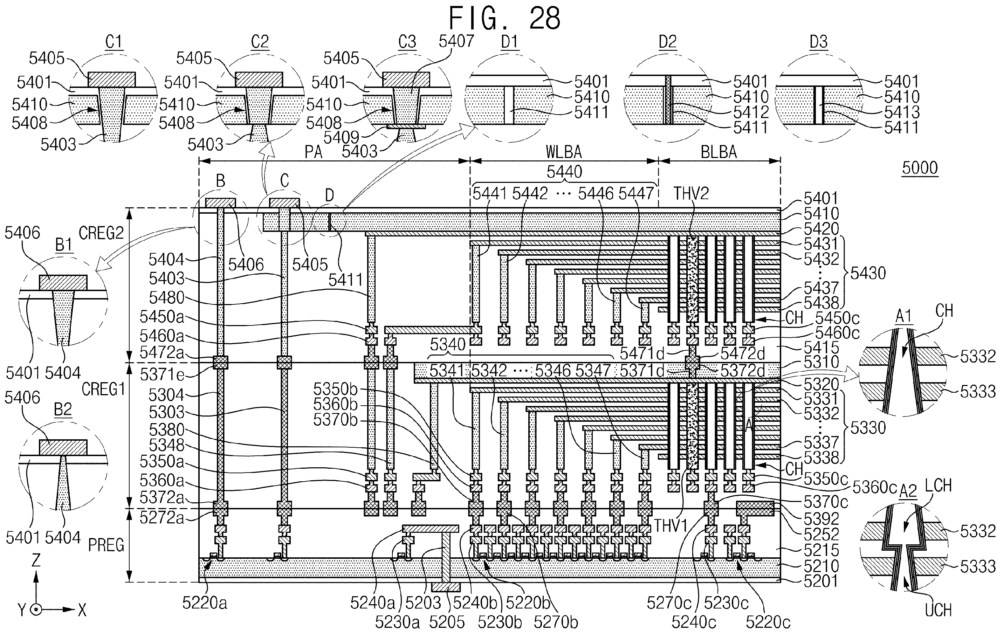

In FIG. 1, only the bitlines BL and BU, the page buffer circuit PGBF, and the page buffer decoder PBD are shown for clarity of illustration, and other components are omitted. As will be further described with reference to FIG. 28, the first cell region CREG1 and the second cell region CREG2 may each further include NAND strings, a plurality of wordlines, source lines, and/or the like. Further, as will be further described with reference to FIG. 10, the peripheral circuit region PREG may include various components.

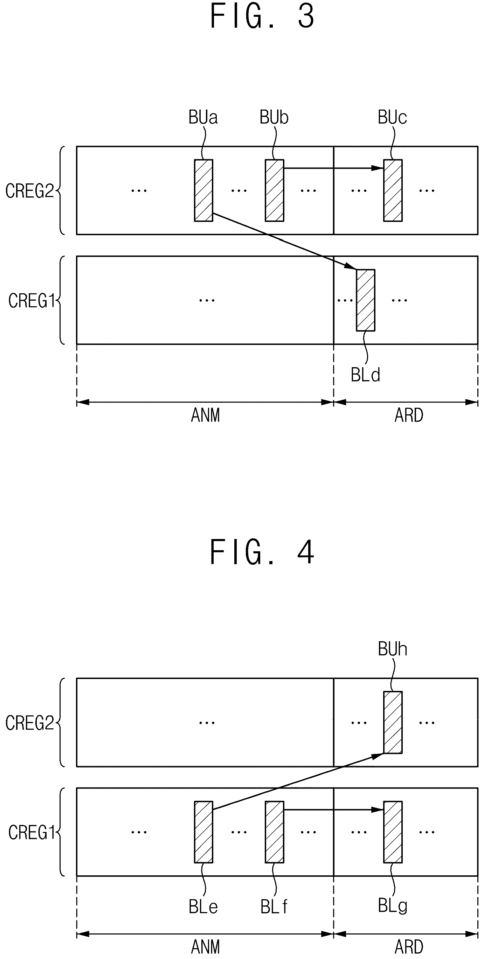

The page buffer decoder PBD may integrate the defective bitlines occurring among the plurality of first normal bitlines NBLL and the plurality of second normal bitlines NBLU and replace the defective bitlines with the plurality of first redundant bitlines RBLL and the plurality of second redundant bitlines RBLU. This integrated column repair of defective bitlines in the first cell region CREG1 and the second cell region CREG2 will be described in more detail with reference to FIGS. 3 through 7.

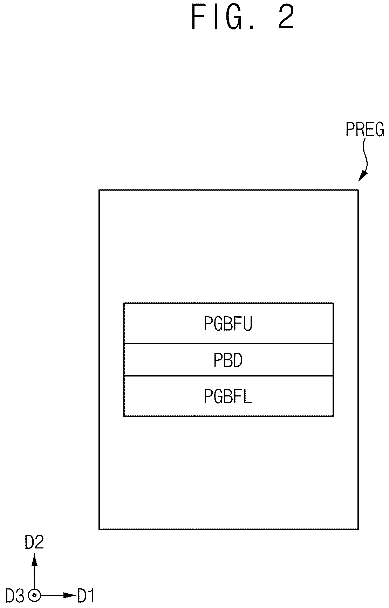

FIG. 2 is a diagram illustrating an example of a layout of a page buffer circuit and a page buffer decoder included in a nonvolatile memory device. Referring to FIG. 1, the page buffer decoder PBD may be formed extending in the first horizontal direction D1. As shown in FIG. 2, a first page buffer circuit PGBFL including page buffers connected to the first normal bitlines NBLL and the first redundant bitlines RBLL may be disposed adjacent to the first side of the page buffer decoder PBD in the second horizontal direction D2. A second page buffer circuit PGBFU including page buffers connected to the second normal bitlines NBLU and the second redundant bitlines RBLU may be disposed adjacent to the second side of the page buffer decoder PBD in the second horizontal direction D2. In this way, by disposing the page buffers corresponding to the first cell region CREG1 and the page buffers corresponding to the second cell region CREG2 adjacent to each of the two sides of the page buffer decoder PBD, the integrated column repair may be efficiently implemented.

FIGS. 3 and 4 are diagrams illustrating an integrated column repair of a nonvolatile memory device. In FIGS. 3 and 4, a normal region ANM denotes a region in which the normal bitlines are disposed, and a redundant region ARD denotes a region in which the redundant bitlines are disposed.

Referring to FIG. 3, the page buffer decoder PBD may perform column repair by integrating the first cell region CREG1 and the second cell region CREG2 with respect to the defective bitlines BUa and BUb that occur among the second cell region CREG2. For example, the defective bitline BUb in the second cell region CREG2 may be replaced by the redundant bitline BUc in the second cell region CREG2, and the defective bitline BUa in the second cell region CREG2 may be replaced by the redundant bitline BLd in the first cell region CREG1.

Referring to FIG. 4, the page buffer decoder PBD may perform column repair by integrating the first cell region CREG1 and the second cell region CREG2 with respect to the defective bitlines BLe and BLf that occur among the first cell region CREG1. For example, the defective bitline BLf of the first cell region CREG1 may be replaced by the redundant bitline BLg of the first cell region CREG1, and the defective bitline BLe of the first cell region CREG1 may be replaced by the redundant bitline BUh of the second cell region CREG2.

In this way, the page buffer decoder PBD may be used to perform column repair by integrating the first cell region CREG1 and the second cell region CREG2. For example, the defective bitlines occurring among the plurality of first normal bitlines NBLL may be replaced with first redundant bitlines RBLL and second redundant bitlines RBLU. Further, the defective bitlines occurring among the plurality of second normal bitlines NBLU may be replaced by the first redundant bitlines RBLL and the second redundant bitlines RBLU.

Referring now to FIGS. 5 through 7, examples of a configuration and operation for implementing the integrated column repair will be described.

FIG. 5 is a diagram illustrating an example of a layout of a page buffer circuit and a page buffer decoder included in a nonvolatile memory device.

FIG. 5 illustrates a page buffer decoder PBD, a first page buffer circuit PGBFL, and a second page buffer circuit PGBFU disposed in a peripheral circuit region PREG. As described with reference to FIG. 2, the first page buffer circuit PGBFL and the second page buffer circuit PGBFU may be disposed adjacent to each of two sides in the first horizontal direction D1 of the page buffer decoder PBD. FIG. 5 illustrates an example in which two redundant bitlines are allocated for the eight normal bitlines, but the bitline configuration is not limited thereto. The first number of normal bitlines, the second number of redundant bitlines, and/or the ratio of the first number to the second number may be determined variously.

Referring to FIG. 5, a page buffer decoder PBD may include a control logic circuit CLG, a first switch circuit SW1, a second switch circuit SW2, and a third switch circuit SW3.

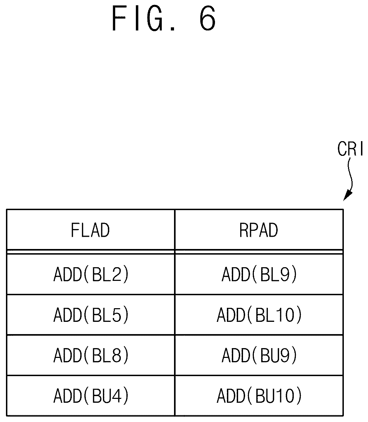

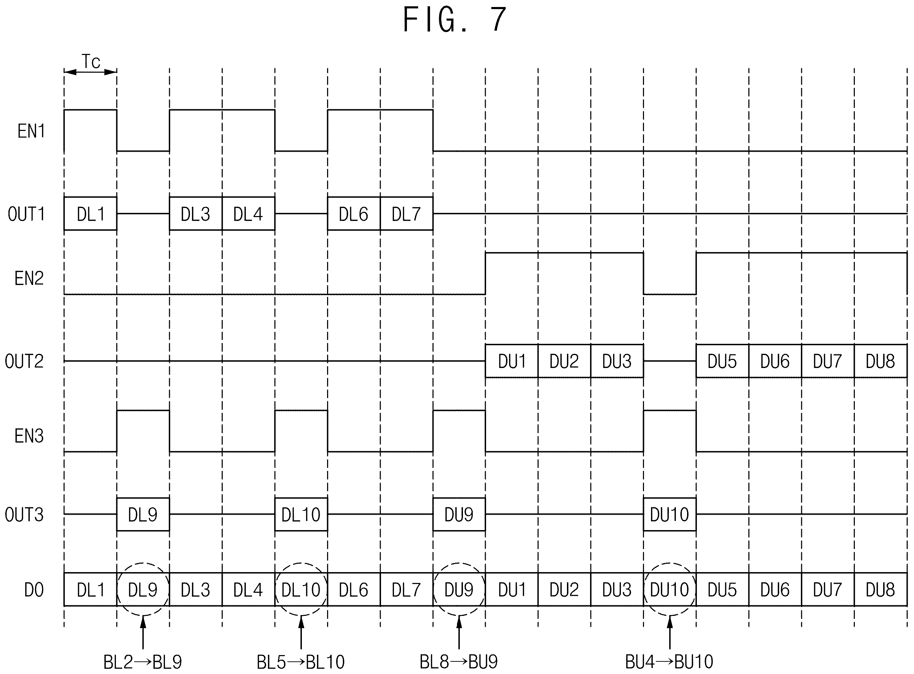

The control logic circuit CLG may generate a first enable signal EN1, a second enable signal EN2, and a third enable signal EN3 based on a column address C_ADDR and column repair information CRI. The control logic circuit CLG may include storage circuit, such as a fuse circuit, a latch circuit, for storing the column repair information CRI. The column repair information CRI and operation of the control logic circuit CLG will be described below with reference to FIGS. 6 and 7.

The first switch circuit SW1 is connected to the page buffers corresponding to the first normal bitlines BL1 to BL8 (NBLL) of the first cell region CREG1. The second switch circuit SW2 is connected to the page buffers corresponding to the second normal bitlines BU1 to BU8 (NBLU) of the second cell region CREG2. The third switch circuit SW3 is connected to the page buffers corresponding to the first redundant bitlines BL9, BL10 (RBLL) of the first cell region CREG1 and the page buffers corresponding to the second redundant bitlines BU9, BU10 (RBLU) of the second cell region CREG2.

The first switch circuit SW1 may control the connection between the page buffers PB connected to the plurality of first normal bitlines NBLL and the input-output line WOR based on the first enable signal EN1. The second switch circuit SW2 may control the connection between the page buffers PB connected to the plurality of second normal bitlines NBLU and the input-output line WOR based on the second enable signal EN2. The third switch circuit SW3 may control the connection between the first redundant bitlines RBLL and RBLU and the input-output line WOR based on the third enable signal EN3.

FIG. 6 is a diagram illustrating an example of column repair information of a nonvolatile memory device.

Referring to FIG. 6, the column repair information CRI may include a mapping relationship between a column address of a defective bitline, a defective column address FLAD, and a column address of a redundant bitline that replaces the defective bitline, that is, a repair column address RPAD.

For example, as shown in FIG. 6, three defective bitlines BL2, BL5 and BL8 may occur among the first normal bitlines BL1 to BL8 of the first cell region CREG1 and one defective bitline BU4 may occur among the second normal bitlines BU1 to BU8 of the second cell region CREG2. In this case, the first normal bitline BL2 may be replaced by the first redundant bitline BL9, the first normal bitline BL5 may be replaced by the first redundant bitline BL10, the first normal bitline BL8 may be replaced by the second redundant bitline BU9, and the second normal bitline BU4 may be replaced by the second redundant bitline BU10. The column repair information CRI may include such mapping relationship of the column addresses ADD.

FIG. 7 is a timing diagram illustrating an operation of the page buffer decoder of FIG. 5 corresponding to the column repair information of FIG. 6. FIG. 7 illustrates the read operation corresponding to the configuration of FIG. 5 and the column repair information CRI of FIG. 6. In FIG. 7, a unit cycle Tc corresponds to the time for data to be output from one page buffer.

Referring to FIGS. 5, 6, and 7, the page buffer decoder PBD may generate the first enable signal EN1 based on column repair information for the defective bitlines BL2, BL5, and BL8 of the plurality of first normal bitlines BL1 to BL8. In response to the activation of the first enable signal EN1, the first switch circuit SW1 may output a first switch signal OUT1 including data bits DL1, DL3, DL4, DL6, DL7 output from the first normal bitlines BL1, BL3, BL4, BL6, and BL7 to the input-output line WOR. During the deactivation period of the first enable signal EN1, the first switch circuit SW1 may mask the data bits DL2, DL5, and DL8 output from the first normal bitlines BL2, BL5, and BL8 corresponding to the defective bitlines.

The page buffer decoder PBD may generate the second enable signal EN2 based on the column repair information for the defective bitline BU4 occurring among the plurality of second normal bitlines BU1 to BU8. In response to the activation of the second enable signal EN2, the second switch circuit SW2 may output a second switch signal OUT2 including data bits DU1, DU2, DU3, BU5, DU6, DU7, and DU8 output from the second normal bitlines BU1, BU2, BU3, BU5, BU6, BU7, and BU8 to the input-output line WOR. During the deactivation period of the second enable signal EN2, the second switch circuit SW2 may mask the data bits DU4 output from the second normal bitline BU4 corresponding to the defective bitline.

The page buffer decoder PBD may generate the third enable signal EN3 based on the column repair information for the defective bitlines BL2, BL5, and BL8 occurring among the plurality of first normal bitlines BL1 to BL8 and the column repair information for the defective bitline BU4 occurring among the plurality of second normal bitlines BU1 to BU8. In response to the activation of the third enable signal EN3, the third switch circuit SW3 may output a third switch signal OUT3 including data bits DL9 and DL10 output from the first redundant bitlines BL9 and BL10 and data bits DU9 and DU10 output from the second redundant bitlines BU9 and BU10 to the input-output line WOR.

The data output signal DO output via the input-output line WOR may include the data bits DL2, DL5, DL8, and DU4 of the redundant bitlines BL9, BL10, BU9, and BU10 instead of the data bits DL2, DL5, DL8, and DU4 of the defective bitlines BL2, BL5, BL8, and BU4.

As a result, a merged column repair may be performed in which the defective bitlines BL2, BL5, BL8, and BU4 of the first cell region CREG1 and the second cell region CREG2 are merged and replaced with the redundant bitlines BL9, BL10, BU9, and BU10 of the first cell region CREG1 and the second cell region CREG2.

As such, the nonvolatile memory device 300 may perform a column repair by merging the defective bitlines occurring from the plurality of cell regions CREG1 and CREG2, thereby improving the repair performance and improving the yield of the nonvolatile memory device 300. Furthermore, based on a same repair performance, the consumption of repair resources may be reduced, and the size of the nonvolatile memory device 300 may be reduced.

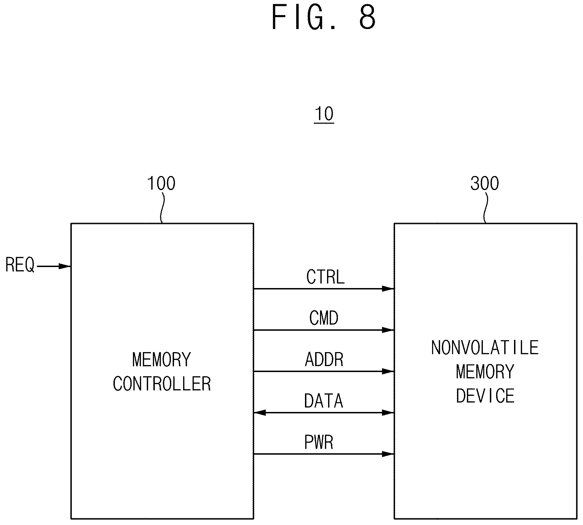

FIG. 8 is a block diagram illustrating an example of a storage device. Referring to FIG. 8, a storage device 10 may include a memory controller (or storage controller) 100 and at least one nonvolatile memory device 300. The storage device 10 illustrated in FIG. 8 may include a data storage medium based on flash memory, such as a memory card, USB memory, SSD, or the like.

The nonvolatile memory device 300 may perform erase, write, or read operations, or the like, under control of the memory controller 100. The nonvolatile memory device 300 receives commands CMD such as read commands and write commands, and addresses ADDR such as read addresses and write addresses, from the memory controller 100 via input and output lines, and transfers and receives data DATA for the read operations or the write operations (or program operations) with the memory controller 100. In addition, the nonvolatile memory device 300 may receive a control signal CTRL via a control line, and the nonvolatile memory device 300 may receive power PWR from the memory controller 100.

The memory controller 100 may control access to the nonvolatile memory device 300 based on requests REQ received from an external host device.

As described above, the nonvolatile memory device 300 may include a plurality of cell regions and the storage device 10 may perform integrated column repair for the plurality of cell regions.

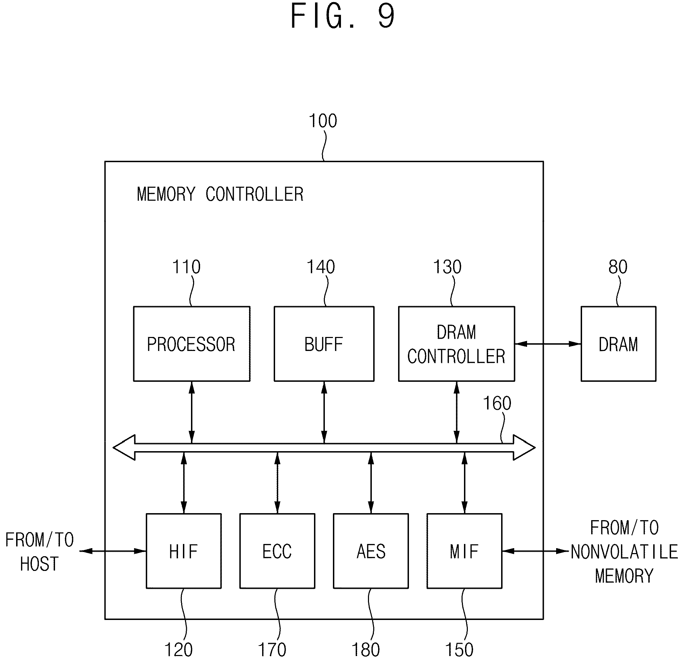

FIG. 9 is a block diagram illustrating an example of a memory controller included in a storage device. Referring to FIG. 9, a memory controller or storage controller 100 may include a processor 110, a buffer memory (BUFF) 140, a DRAM controller 130, a host interface (HIF) 120, an error correction code (ECC) engine 170, a memory interface (MIF) 150, an advanced encryption standard (AES) engine 180, and an internal bus 160 electrically connecting the components.

The processor 110 may control the operation of the storage controller 100 in response to commands received via the host interface 120 from an external host device. For example, the processor 110 may control the operation of a memory system (e.g., storage device 10 in FIG. 8) and may employ firmware to drive the memory system to control respective components.

The buffer memory 140 may store instructions and data that are executed and processed by the processor 110. For example, the buffer memory 140 may be implemented as volatile memory, such as SRAM, DRAM, or the like.

The ECC engine 170 for error correction may perform ECC encoding and ECC decoding using error correction code such as Bose-Chaudhuri-Hocquenghem (BCH) code, Low Density Parity Check (LDPC) code, Turbo Code, Reed-Solomon Code, Convolution Code, Recursive Systematic Code (RSC), Coded Modulation, such as Trellis-Coded Modulation (TCM), Block Coded Modulation (BCM), Hamming code, and so on.

The host interface 120 may provide a physical connection between the host device and the storage controller 100, i.e., the host interface 120 may provide interfacing with the storage controller 100 in a bus format corresponding to the bus format of the host device. In some implementations, the bus format of the host device may be SCSI or SAS. In some implementations, the bus format of the host device may be USB, peripheral component interconnect express (PCIe), ATA, PATA, SATA, NVMe, or the like.

The memory interface 150 may exchange data with a nonvolatile memory device (e.g., 300 in FIG. 8). The memory interface 150 may transfer write data to the nonvolatile memory device 300, and may receive read data from the nonvolatile memory device 300. For example, the memory interface 150 may utilize a standard protocol such as Toggle or ONFI.

The AES engine 180 may perform at least one of encryption operations and decryption operations on data input to the storage controller 100, using a symmetric-key algorithm. Although not shown in detail, the AES engine 180 may include an encryption module and a decryption module. The encryption module and the decryption module may be implemented as separate modules or may be implemented as a single module.

The processor 110 may access the external DRAM 80 via the DRAM controller 130. The processor 110 may control the DRAM controller 130, the memory interface 150, and the host interface 120 to transfer user data stored in the external DRAM 80 to the nonvolatile memory device 300 or to an external host device.

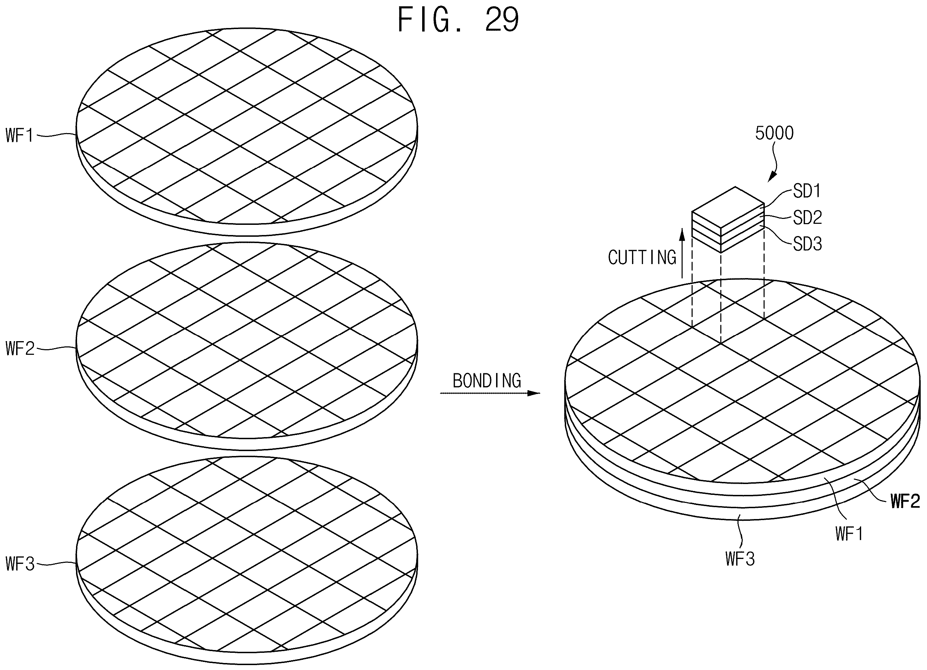

FIG. 10 is a block diagram illustrating an example of a nonvolatile memory device. Referring to FIG. 10, a nonvolatile memory device 300 may include a memory cell array 500, a page buffer circuit (PGBF) 510, a page buffer decoder (PBD) 515, a data input-output (I/O) circuit 520, an address decoder 530, a control circuit 550, and a voltage generator 560. As will be described below with reference to FIGS. 28 and 29, in some implementations, the cell region CREG and the peripheral region PREG may be formed and disposed in different wafers. In addition, in some implementations, the cell region CREG may include a plurality of cell regions that are disposed in different wafers.

The memory cell array 500 may be coupled to the address decoder 530 through string selection lines SSL, wordlines WL, and ground selection lines GSL. In addition, the memory cell array 500 may be coupled to the page buffer circuit 510 through bitlines BL. The memory cell array 500 may include memory cells coupled to the wordlines WL and the bitlines BL. In some implementations, the memory cell array 500 may be a three-dimensional memory cell array, which is formed on a substrate in a three-dimensional structure (for example, a vertical structure). In this case, the memory cell array 500 may include cell strings (e.g., NAND strings) that are vertically oriented such that at least one memory cell is overlapped vertically with another memory cell.

The control circuit 550 may receive a command (signal) CMD and an address (signal) ADDR from a memory controller. Accordingly, the control circuit 550 may control erase, program and read operations of the nonvolatile memory device 1000 in response to (or based on) at least one of the command signal CMD and the address signal ADDR. An erase operation may include performing a sequence of erase loops. A program operation may include performing a sequence of program loops. Each program loop may include a program operation and a program verification operation. Each erase loop may include an erase operation and an erase verification operation. The read operation may include a normal read operation and a data recover read operation.

For example, the control circuit 550 may generate the control signals CTL used to control the operation of the voltage generator 560. The control circuit 550 may also generate the page buffer control signal PBC for controlling the page buffer circuit 510 based on the command signal CMD, and generate the block address B_ADDR, the row address R_ADDR and the column address C_ADDR based on the address signal ADDR. The control circuit 550 may provide the block address B_ADDR and the row address R_ADDR to the address decoder 530 and provide the column address C_ADDR to the data I/O circuit 520.

The address decoder 530 may be coupled to the memory cell array 500 through the string selection lines SSL, the wordlines WL, and the ground selection lines GSL. During the program operation or the read operation, the address decoder 530 may determine or select one of the wordlines WL as a selected wordline and determine the remaining wordlines WL except for the selected wordline as unselected wordlines based on the row address R_ADDR.

During the program operation or the read operation, the address decoder 530 may determine one of the string selection lines SSL as a selected string selection line and determine the remaining string selection lines SSL except for the selected string selection line as unselected string selection lines based on the row address R_ADDR.

The voltage generator 560 may generate wordline voltages VWL, which are required for the operation of the memory cell array 500 of the nonvolatile memory device 1000, based on the control signals CTL. The voltage generator 560 may receive power PWR from a memory controller such as the memory controller 100 in FIG. 8. The wordline voltages VWL may be applied to the wordlines WL through the address decoder 530.

For example, during the erase operation, the voltage generator 560 may apply an erase voltage to a well and/or a common source line of a memory block and apply an erase permission voltage (e.g., a ground voltage) to all or a portion of the wordlines of the memory block based on an erase address. During the erase verification operation, the voltage generator 560 may apply an erase verification voltage simultaneously to all of the wordlines of the memory block or sequentially (e.g., one by one) to the wordlines.

For example, during the program operation, the voltage generator 560 may apply a program voltage to the selected wordline and may apply a program pass voltage to the unselected wordlines. In addition, during the program verification operation, the voltage generator 560 may apply a program verification voltage to the first wordline and may apply a verification pass voltage to the unselected wordlines.

During the normal read operation, the voltage generator 560 may apply a read voltage to the selected wordline and may apply a read pass voltage to the unselected wordlines. During the data recover read operation, the voltage generator 560 may apply the read voltage to a wordline adjacent to the selected wordline and may apply a recover read voltage to the selected wordline.

The page buffer circuit 510 may be coupled to the memory cell array 500 through the bitlines BL. The page buffer circuit 510 may include multiple buffers. In some implementations, each buffer may be connected to a single bitline. In some implementations, each buffer may be connected to two or more bitlines. The page buffer circuit 510 may temporarily store data to be programmed in a selected page or data read from the selected page of the memory cell array 500.

The page buffer decoder 515 may control the connection between the page buffer circuit 510 and the data lines DL based on the row address R_ADDR provided from the control circuit 550 and the column repair information stored therein. The page buffer decoder 515 may perform the integrated column repair as described above.

The data I/O circuit 520 may be coupled to the page buffer circuit 510 through data lines DL. During the program operation, the data I/O circuit 520 may receive program data DATA received from the memory controller and provide the program data DATA to the page buffer circuit 510 based on the column address C_ADDR received from the control circuit 550. During the read operation, the data I/O circuit 520 may provide read data DATA, having been read from the memory cell array 500 and stored in the page buffer circuit 510, to the memory controller based on the column address C_ADDR received from the control circuit 550.

In addition, the page buffer circuit 510 and the data I/O circuit 520 may read data from a first area of the memory cell array 500 and write the read data to a second area of the memory cell array 500 (e.g., without transferring the data to a source external to the nonvolatile memory device 1000, such as to the memory controller). For example, the page buffer circuit 510 and the data I/O circuit 520 may perform a copy-back operation.

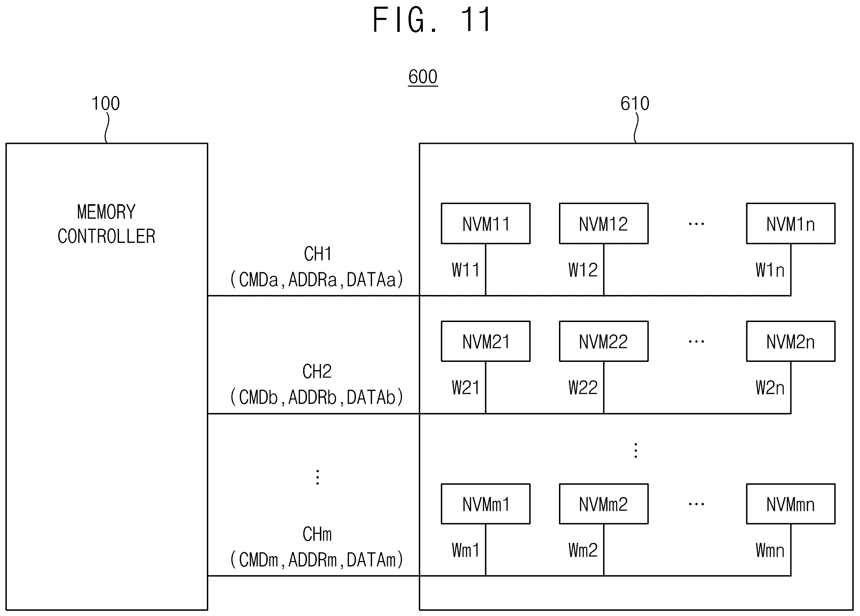

FIG. 11 is a block diagram illustrating an example of a storage device. Referring to FIG. 11, a storage device 600 may include a nonvolatile memory device 610 and a memory controller 100. The storage device 600 may support a plurality of channels CH1, CH2, ..., CHm, and the nonvolatile memory device 610 may be connected to the memory controller 100 through the plurality of channels CH1 to CHm. For example, the storage device 600 may be implemented as a universal flash storage (UFS), a solid state drive (SSD), or the like. The storage device 600 may correspond to the storage device 10 of FIG. 8.

The nonvolatile memory device 610 may include a plurality of nonvolatile memories NVM11, NVM12, ..., NVM1n, NVM21, NVM22, ..., NVM2n, NVMm1, NVMm2, ..., NVMmn. Here, n and m may each be integers. Each of the nonvolatile memories NVM11 to NVMmn may be connected to one of the plurality of channels CH1 to CHm through a way corresponding thereto. For example, the nonvolatile memories NVM11 to NVM1n may be connected to the first channel CH1 through ways W11, W12, ..., W1n, the nonvolatile memories NVM21 to NVM2n may be connected to the second channel CH2 through ways W21, W22, ..., W2n, and the nonvolatile memories NVMm1 to NVMmn may be connected to the m-th channel CHm through ways Wm1, Wm2, ..., Wmn. In some implementations, each of the nonvolatile memories NVM11 to NVMmn may be implemented as a memory unit that may operate according to an individual command from the memory controller 100. For example, each of the nonvolatile memories NVM11 to NVMmn may be implemented as a chip or a die, but implementations are not limited thereto.

The memory controller 100 may transmit and receive signals to and from the nonvolatile memory device 610 through the plurality of channels CH1 to CHm. For example, the memory controller 100 may transmit commands CMDa, CMDb, ..., CMDm, addresses ADDRa, ADDRb, ..., ADDRm and data DATAa, DATAb, ..., DATAm to the nonvolatile memory device 610 through the channels CH1 to CHm, or may receive the data DATAa to DATAm from the nonvolatile memory device 610 through the channels CH1 to CHm.

The memory controller 100 may select one of the nonvolatile memories NVM11 to NVMmn, which is connected to each of the channels CH1 to CHm, using a corresponding one of the channels CH1 to CHm, and may transmit and receive signals to and from the selected nonvolatile memory. For example, the memory controller 100 may select the nonvolatile memory NVM11 from among the nonvolatile memories NVM11 to NVM1n connected to the first channel CH1. The memory controller 100 may transmit the command CMDa, the address ADDRa and the data DATAa to the selected nonvolatile memory NVM11 through the first channel CH1 or may receive the data DATAa from the selected nonvolatile memory NVM11 through the first channel CH1.

The memory controller 100 may transmit and receive signals to and from the nonvolatile memory device 610 in parallel through different channels. For example, the memory controller 100 may transmit the command CMDb to the nonvolatile memory device 610 through the second channel CH2 while transmitting the command CMDa to the nonvolatile memory device 610 through the first channel CH1. For example, the memory controller 100 may receive the data DATAb from the nonvolatile memory device 610 through the second channel CH2 while receiving the data DATAa from the nonvolatile memory device 610 through the first channel CH1.

The memory controller 100 may control overall operations of the nonvolatile memory device 610. The memory controller 100 may transmit a signal to the channels CH1 to CHm and may control each of the nonvolatile memories NVM11 to NVMmn connected to the channels CH1 to CHm. For example, the memory controller 100 may transmit the command CMDa and the address ADDRa to the first channel CH1 and may control one selected from among the nonvolatile memories NVM11 to NVM1n.

Each of the nonvolatile memories NVM11 to NVMmn may operate under the control of the memory controller 100. For example, the nonvolatile memory NVM11 may program the data DATAa based on the command CMDa, the address ADDRa and the data DATAa provided from the memory controller 100 through the first channel CH1. For example, the nonvolatile memory NVM21 may read the data DATAb based on the command CMDb and the address ADDRb provided from the memory controller 100 through the second channel CH2 and may transmit the read data DATAb to the memory controller 100 through the second channel CH2.

Although FIG. 11 illustrates an example where the nonvolatile memory device 610 communicates with the memory controller 100 through m channels and includes n nonvolatile memories corresponding to each of the channels, the channel configuration is not limited thereto and the number of channels and the number of nonvolatile memories connected to one channel may be variously changed.

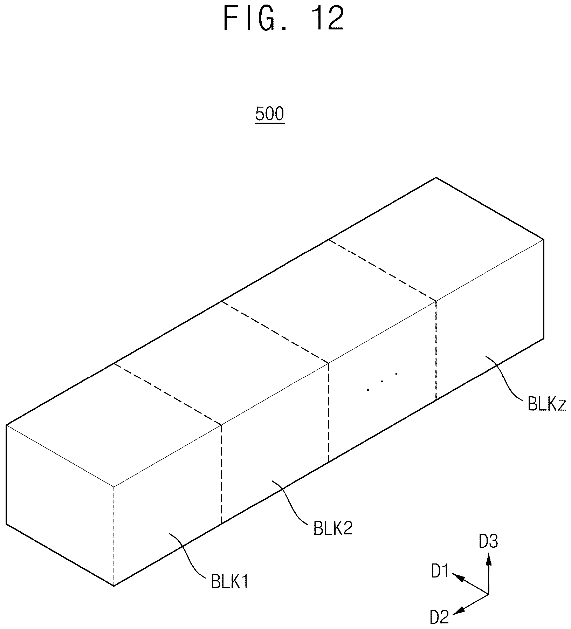

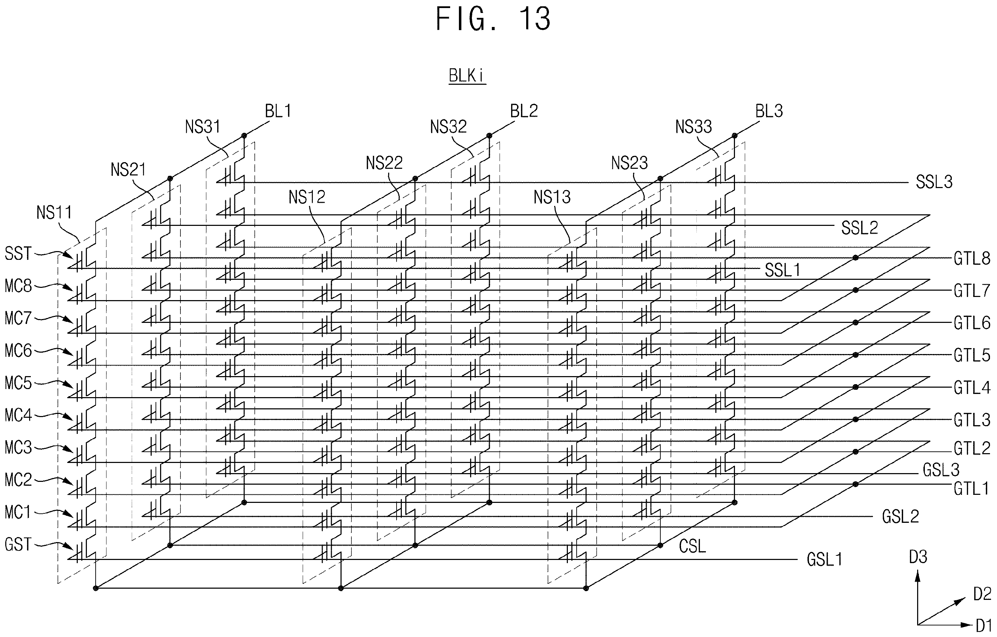

FIG. 12 is a block diagram illustrating an example of a memory cell array included in a nonvolatile memory device (e.g., the nonvolatile memory device of FIG. 10), and FIG. 13 is a circuit diagram illustrating an equivalent circuit of a memory block included in a memory cell array (e.g., the memory cell array of FIG. 12).

Referring to FIG. 12, the memory cell array 500 may include memory blocks BLK1 to BLKz. In some implementations, the memory blocks BLK1 to BLKz may be selected by the address decoder 530 in FIG. 10. For example, the address decoder 530 may select a particular memory block BLK among the memory blocks BLK1 to BLKz corresponding to a block address.

The memory block BLKi of FIG. 13 may be formed on a substrate in a three-dimensional structure (for example, a vertical structure). For example, NAND strings or cell strings included in the memory block BLKi may be disposed in the vertical direction D3 perpendicular to the upper surface of the substrate.

Referring to FIG. 13, the memory block BLKi may include cell strings or NAND strings NS11 to NS33 coupled between bitlines BL1, BL2 and BL3 and a common source line CSL. Each NAND string may include a plurality of memory cells stacked in the vertical direction D3, and the plurality of wordlines may be stacked in the vertical direction D3.

Each of the NAND strings NS11 to NS33 may include a string selection transistor SST, memory cells MC1 to MC8, and a ground selection transistor GST. In FIG. 13, each of the NAND strings NS11 to NS33 is illustrated to include eight memory cells MC1 to MC8. However, the number of memory cells is not limited thereto. In some implementations, each of the NAND strings NS11 to NS33 may include any number of memory cells.

Each string selection transistor SST may be connected to a corresponding string selection line (for example, one of SSL1 to SSL3). The memory cells MC1 to MC8 may be connected to corresponding gate lines GTL1 to GTL8, respectively. The gate lines GTL1 to GTL8 may be wordlines. Some of the gate lines GTL1 to GTL8 may be dummy wordlines. Each ground selection transistor GST may be connected to a corresponding ground selection line (for example, one of GSL1 to GSL3). Each string selection transistor SST may be connected to a corresponding bitline (e.g., one of BL1, BL2 and BL3). Each ground selection transistor GST may be connected to the common source line CSL.

Wordlines (each of the gate lines GTL1 to GTL8) having the same height may be commonly connected. The ground selection lines GSL1 to GSL3 and the string selection lines SSL1 to SSL3 may be separated. In FIG. 13, the memory block BLKi is illustrated to be coupled to eight gate lines GTL1 to GTL8 and three bitlines BL1 to BL3. However, connection configurations are not limited thereto. Each memory block in the memory cell array 500 may be coupled to any number of wordlines and any number of bitlines.

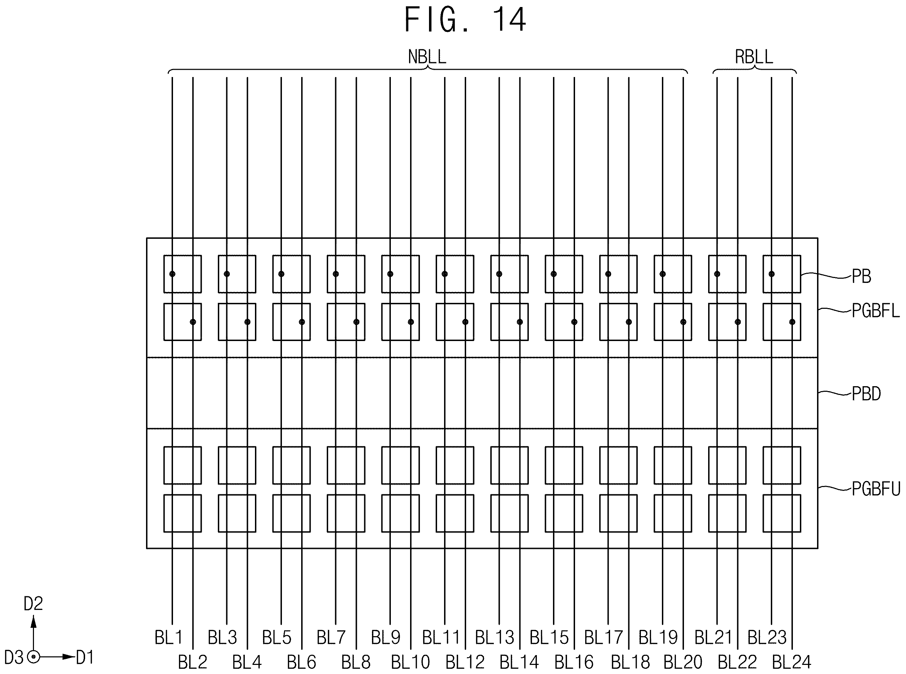

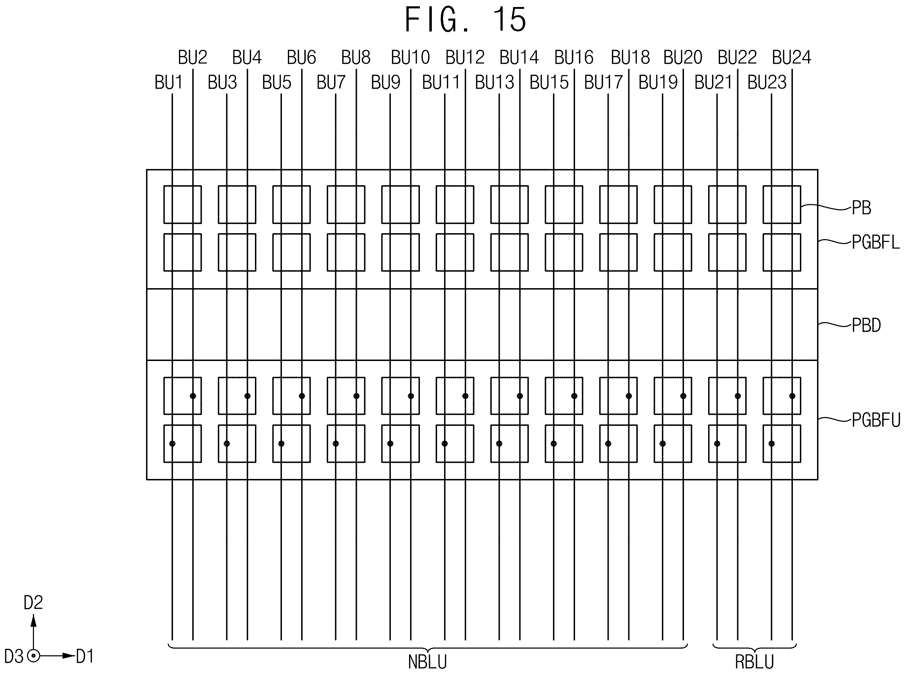

FIGS. 14 and 15 are diagrams illustrating an example of a connection of bitlines and page buffers of a nonvolatile memory device. FIG. 14 illustrates an example of a configuration of connecting first normal bitlines BL1 to BL20 (NBLL) and first redundant bitlines BL21 to BL24 (RBLL) disposed in a first cell region CREG1 and page buffers PB of a first page buffer circuit PGBFL disposed adjacent to one side in the second horizontal direction D2 of a page buffer decoder PBD. FIG. 15 illustrates an example of a configuration of connecting the page buffers PB of the second page buffer circuit PGBFU disposed adjacent to one side in the second horizontal direction D2 of the page buffer decoder PBD with the second normal bitlines BU1 to BU20 (NBLU) and the second redundant bitlines BU21 to BU24 (RBLU) disposed in the second cell region CREG1.

As shown in FIGS. 14 and 15, one page buffer PB may be connected to each bitline. In some cases, if the length in the first horizontal direction D1 of each page buffer PB is greater than the pitch between two adjacent bitlines, it is not possible, or difficult, to arrange the page buffers PB included in each of the first and second page buffer circuits PGBFL, PGBFU in the first horizontal direction D1 in a single line. To facilitate the connections, the page buffers PBs may be arranged in two or more lines and the bitlines and page buffers PBs may be connected in a zigzag manner, as shown in FIGS. 14 and 15.

As shown in FIGS. 14 and 15, the plurality of first normal bitlines NBLL and the plurality of first redundant bitlines RBLL may be arranged to overlap with the plurality of second normal bitlines NBLU and the plurality of second redundant bitlines RBLU in the vertical direction D3. For example, the first cell region CREG1 and the second cell region CREG2 may be manufactured in the same structure by the same manufacturing process to facilitate mass production.

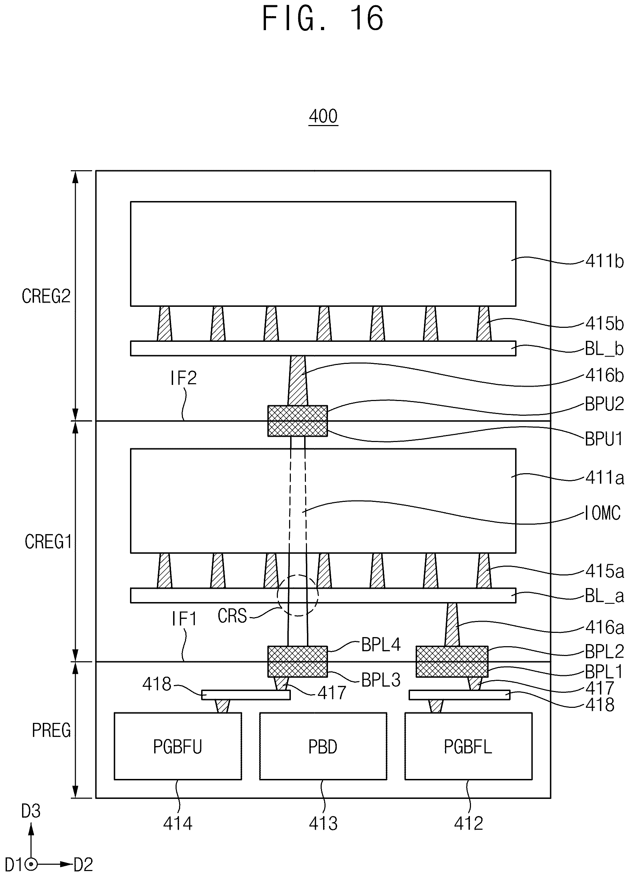

FIG. 16 is a cross-sectional diagram illustrating an example of a vertical structure of a nonvolatile memory device.

Referring to FIG. 16, a nonvolatile memory device 400 may include a peripheral circuit region PREG, a first cell region CREG1, and a second cell region CREG2 stacked in sequence in the vertical direction D3. A first memory cell array 411a may be disposed within the first cell region CREG1, and a second memory cell array 411b may be disposed within the second cell region CREG2. A first page buffer circuit PGBFL 412, a page buffer decoder PBD 413, and a second page buffer circuit PGBFU 414 may be disposed within the peripheral circuit region PREG.

The peripheral circuit region PREG and the first cell region CREG1 may be attached to each other by low-level bonding pads BPL1, BPL2, BPL3, and BPL4 at the first bonding interface IF1, and the first cell region CREG1 and the second cell region CREG2 may be attached to each other by high-level bonding pads BPU1 and BPU2 at the second bonding interface IF2. The low-level bonding pads BPL1, BPL2, BPL3, and BPL4 and high-level bonding pads BPU1, and BPU2 may be disposed in bonding pad regions disposed within the memory cell arrays 411a and 411b from a planar perspective. In some implementations, the bonding pad regions in the nonvolatile memory device 400 may be disposed in a plurality of regions.

The first memory cell array 411a within the first cell region CREG1 may be connected to a low-level bitline BL_a via bitline contacts 415a, and the low-level bitline BL_a may be electrically connected to the low-level bonding pads BPL1 and BPL2 via connection vias 416a. The low-level bitline BL_a corresponds to the first bitline BL described above. The second memory cell array 411b in the second cell region CREG2 is connected to the high-level bitline BL_b via bitline contacts 415b, and the high-level bitline BL_b may be electrically connected to the high-level bonding pads BPU1 and BPU2 via connection vias 416b. The high-level bitline BL_b corresponds to the second bitline BU described above.

The first cell region CREG1 may further include an input-output contact IOMC, which may penetrate a portion of the first memory cell array 411a to electrically connect the low-level bonding pads BPL3 and BPL4 to the high-level bonding pads BPU1 and BPU2. The low-level bonding pads BPL1 and BPL2 may be electrically connected to the first page buffer circuit PGBFL through vias 417 and wiring layer 418 disposed within the peripheral circuit region PREG. The low-level bonding pads BPL3 and BPL4 may be electrically connected to the second page buffer circuit PGBFU through via 417 and wiring layer 418 disposed within the peripheral circuit region PREG.

In some implementations, the first memory cell array 411a in the first cell region CREG1 may store m bits per cell and the second memory cell array 411b in the second cell region CREG2 may store n bits per cell, where n may be different from or equal to m. In some implementations, both the first and second memory cell arrays 411a, 411b may be single level cell memories storing 1 bit per cell. In some implementations, both the first and second memory cell arrays 411a, 411b may be multi-level cell memories storing two bits per cell. In some implementations, both the first and second memory cell arrays 411a, 411b may be triple level cell memories storing 3 bits per cell. In some implementations, the first memory cell array 411a may be a multi-level cell memory and the second memory cell array 411b may be a single-level cell memory. In some implementations, the first memory cell array 411a may be a triple-level cell memory and the second memory cell array 411b may be a multi-level cell memory or a single-level cell memory. In some implementations, the first memory cell array 411a may be a single-level cell memory and the second memory cell array 411b may be a multi-level cell memory. In some implementations, the first memory cell array 411a may be a multi-level cell memory or a single-level cell memory and the second memory cell array 411b may be a triple-level cell memory.

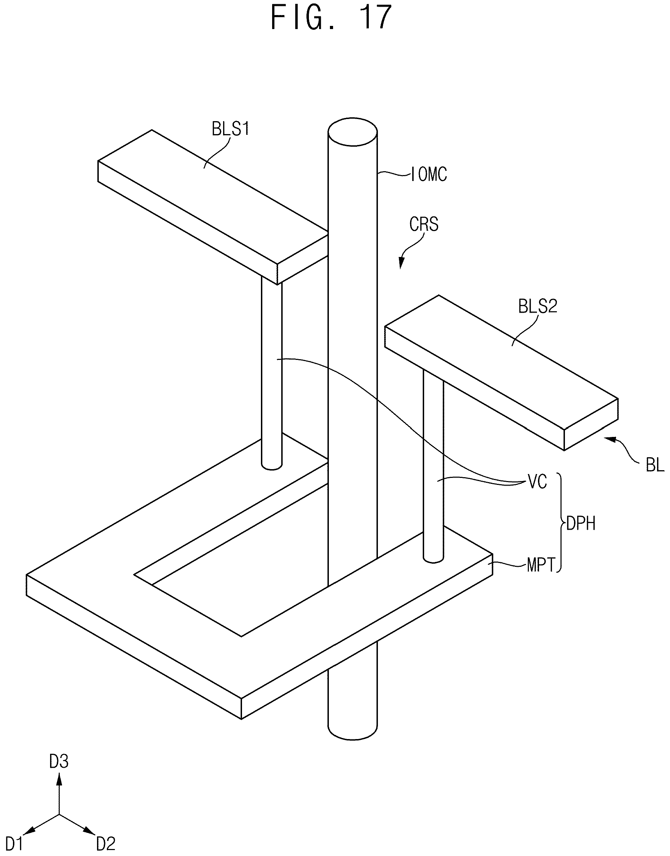

FIG. 17 is a diagram illustrating an example of an intersection region of bitlines and input-output contacts of the nonvolatile memory device of FIG. 16, for example, the intersection region CRS.

As described with reference to FIGS. 14 and 15, the plurality of first normal bitlines NBLL and the plurality of first redundant bitlines RBLL may be arranged to overlap with the plurality of second normal bitlines NBLU and the plurality of second redundant bitlines RBLU in the vertical direction D3.

In this case, the plurality of second normal bitlines NBLU and the plurality of second redundant bitlines RBLU included in the second cell region CREG2 may be connected to the page buffers PB included in the peripheral circuit region PREG via vertical conduction paths passing through the first cell region (e.g., input-output contacts IOMC in FIG. 16).

As shown in FIG. 17, each bitline BL of the plurality of second normal bitlines NBLU and the plurality of second redundant bitlines RBLU may be cut into two segments BLS1 and BLS2 in the intersection region CRS through which the vertical conduction path IOMC passes. The two segments BLS1 and BLS2 may be connected to each other through a detour conduction path DPH formed spaced apart from the vertical conduction path IOMC. For example, the detour conduction path DPH may include a conduction pattern MPT formed in a conduction layer and vertical contacts VC connecting the conduction pattern MPT and the segments BLS1 and BLS2.

As such, when the first bitlines BL of the first cell region CREG1 include a detour conduction path, the bitline defect rate of the first cell region CREG1 may be greater than the bitline defect rate of the second cell region CREG2. In this case, the yield of the nonvolatile memory device may be improved by replacing the defective bitlines in the first cell region CREG1 with redundant bitlines in the second cell region CREG2 according to the integrated column repair.

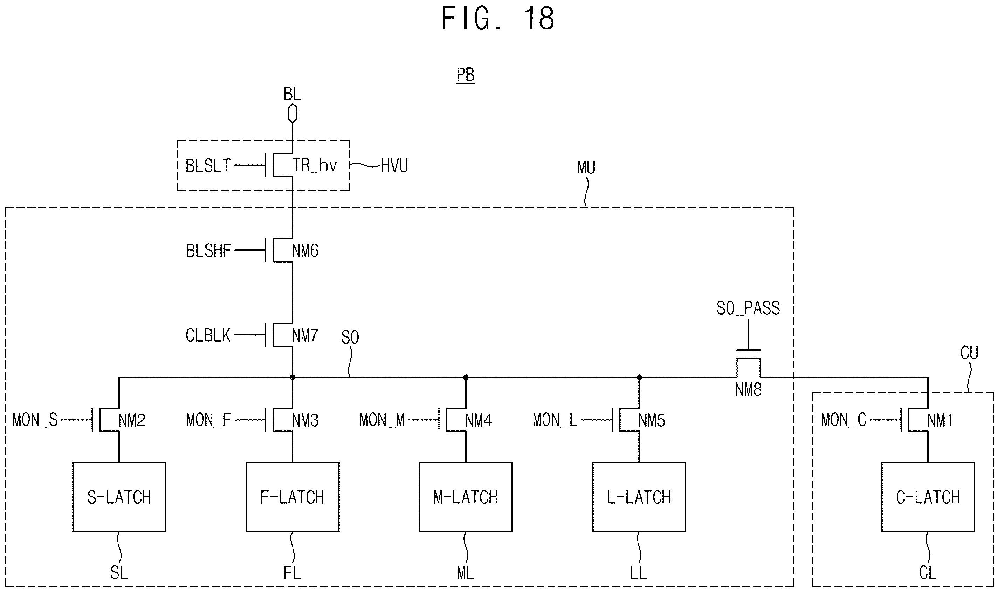

FIG. 18 is a circuit diagram illustrating an example of a page buffer included in a nonvolatile memory device. Referring to FIG. 18, a page buffer PB may include a high-voltage unit HVU, a main unit MU, and a cache unit CU.

The high-voltage unit HVU may include a bitline select transistor TR_hv connected to a bitline BL and driven by a bitline select signal BLSLT. The bitline select transistor TR_hv may be implemented as a high-voltage transistor to reduce the effects of high voltages (e.g., an erase voltage), and accordingly, the bitline select transistor TR_hv may be disposed in a different well region than the main unit MU.

The cache unit CU may include a cache latch (C-LATCH) CL, and the cache latch CL may be connected to the data input and output (I/O) lines. Accordingly, the cache unit CU may be disposed adjacent to the data I/O lines. For example, the main unit MU and the cache unit CU may be spaced apart from each other. The cache unit CU may further include a first transistor NM1. The first transistor NM1 may be driven according to a cache monitoring signal MON_C.

The main unit MU may include major transistors within the page buffer PB. For example, the main unit MU may include a sense latch (S-LATCH) SL, a force latch (F-LATCH) FL, a high bit latch (M-LATCH) ML, and a low bit latch (L-LATCH) LL. The sense latch SL may store the data stored in the memory cell or the sensing result of the threshold voltage of the memory cell during a read or program verify operation. The sense latch SL may also be utilized to apply a program bitline voltage or a program inhibit voltage to the bitline BL during program operation. The force latch FL may be utilized to improve threshold voltage spread during program operation. For example, the force latch FL stores force data. The force data may be initially set to '1' and then inverted to '0' when the threshold voltage of the memory cell enters the forcing region below the target region. Force data may be used to control bitline voltages during program execution operation and to form a narrower program threshold voltage spread.

The upper bit latch ML, lower bit latch LL, and cache latch CL may be utilized to store externally input data during program operation. When programming 3 bits of data into one memory cell, the 3 bits of data may be stored in the upper bit latch ML, the lower bit latch LL, and the cache latch CL, respectively. However, storage configurations are not limited to this, and the 3-bit data received through the cache latch CL may be stored in the force latch FL, the high bit latch ML, and the low bit latch LL, respectively. Until the programming of the memory cell is completed, the high bit latch ML, the low bit latch LL, and the cache latch CL may retain the stored data. In addition, the cache latch CL may receive data read from the memory cell from the sense latch SL in a read operation and output the data to the outside via the data input-output line.

The main unit MU may further include second to fifth transistors NM2 to NM5. The second transistor NM2 may be connected between the sensing node SO and the sensing latch SL, and may be driven by a sensing monitoring signal MON_S. The third transistor NM3 may be connected between the sensing node SO and the force latch FL, and may be driven by a forcing monitoring signal MON_F. The fourth transistor NM4 may be connected between the sensing node SO and the high bit latch ML, and may be driven by a high bit monitoring signal MON_M. The fifth transistor NM5 may be connected between the sensing node SO and the low bit latch LL, and may be driven by a low bit monitoring signal MON_L.

The main unit MU may further include sixth and seventh transistors NM6 and NM7 connected in series between the bitline select transistor TR_hv and the sensing node SO. The sixth transistor NM6 may be driven by a bitline shut-off signal BLSHF, and the seventh transistor NM7 may be driven by a bitline connection control signal CLBLK. The main unit MU may further include an eighth transistor NM8 connected to the sensing node SO. The eighth transistor NM8 may be referred to as a 'pass transistor' and may be driven by a pass control signal SO_PASS.

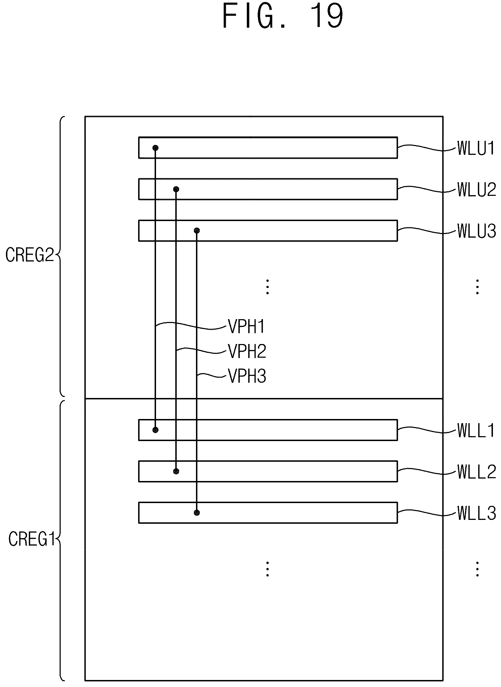

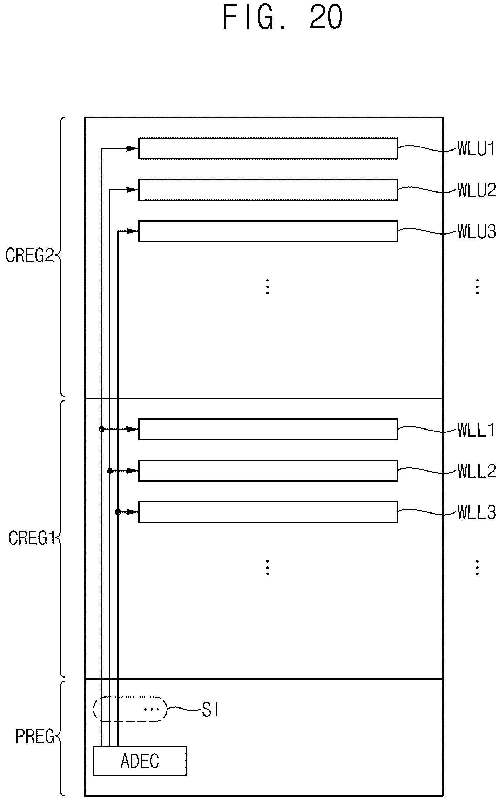

FIGS. 19 and 20 are diagrams illustrating examples of a double drive wordline (DDWL) structure of a nonvolatile memory device.

Referring to FIGS. 19 and 20, a first cell region CREG1 may include a plurality of first wordlines WLL1 to WLL3, and a second cell region CREG2 may include a plurality of second wordlines WLU1 to WLU3.

A first selected wordline corresponding to a row address (R_ADDR in FIG. 10) of the plurality of first wordlines WLL1 to WLL3 and a second selected wordline corresponding to the row address of the plurality of second wordlines WLU1 to WLU3 may be enabled simultaneously.

In some implementations, as shown in FIG. 19, the first selected wordline and the second select wordline may be electrically connected through a conduction path. For example, the first wordline WLL1 may be connected to the second wordline WLU1 via the conduction path VPH1, the first wordline WLL2 may be connected to the second wordline WLU2 via the conduction path VPH2, and the first wordline WLL3 may be connected to the second wordline WLU3 via the conduction path VPH3.

In some implementations, as shown in FIG. 20, a plurality of drive signals SI generated by the address decoder (ADEC) (e.g., 530 in FIG. 10) based on the row address R_ADDR may be applied commonly to the plurality of first wordlines WLL1 to WLL3 and the plurality of second wordlines WLU1 to WLU3. The plurality of drive signals SI may include a plurality of string select signals SS, a plurality of wordline drive signals S0 to S63, and a plurality of ground select signals GS.

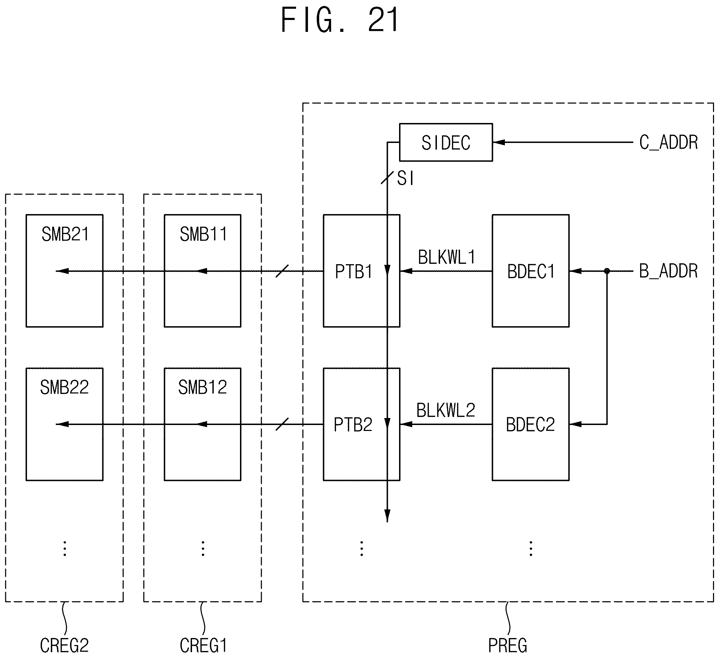

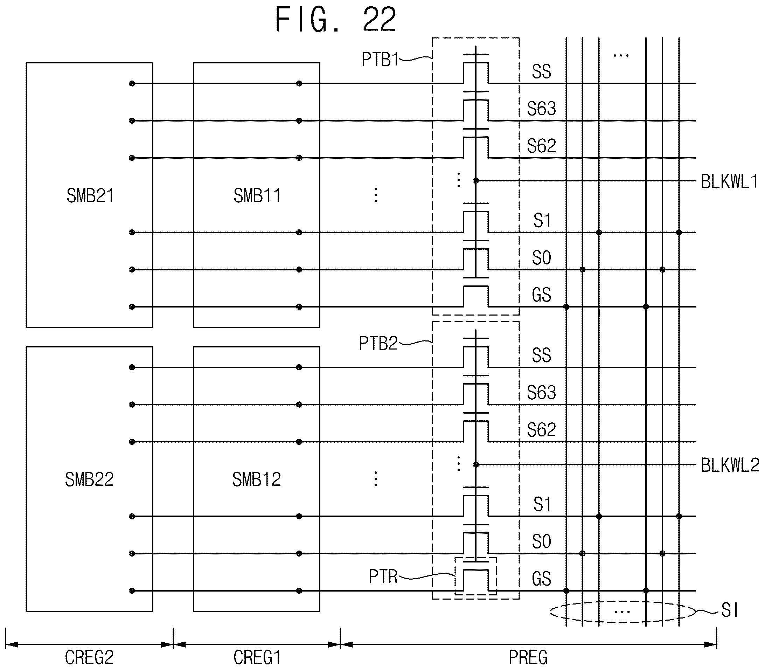

FIG. 21 is a diagram illustrating an example of a configuration corresponding to the DDWL structure of FIG. 20, and FIG. 22 is a diagram illustrating an example of a pass transistor circuit in FIG. 21.

FIG. 21 illustrates an example of a row decoder and a pass transistor circuit included in a nonvolatile memory device. For convenience of illustration and description, two sub-memory blocks SMB11 and SMB12 of a first cell region CREG1, two sub-memory blocks SMB21 and SMB22 of a second cell region CREG2, and corresponding address decoder and a pass transistor circuit are shown in FIG. 21, but implementations within the scope of this disclosure are not limited to a particular number of memory blocks.

Referring to FIG. 21, the aforementioned address decoder may include a drive signal decoder SIDEC and first and second block decoders BDEC1 and BDEC2 corresponding to the sub-memory blocks SMB11, SMB12, SMB21, and SMB22. The pass transistor circuit may include first and second pass transistor blocks PTB1 and PTB2 corresponding to the sub-memory blocks SMB11, SMB12, SMB21, and SMB22.

The drive signal decoder SIDEC may generate a plurality of drive signals SI based on the row address R_ADDR. The drive signal decoder SIDEC may determine voltage levels of the plurality of drive signals SI to correspond to program operation, read operation, and erase operation, respectively.

Depending on the DDWL structure, one sub-memory block of the first cell region CREG1 and one sub-memory block of the second cell region CREG2 may be selected simultaneously, and the two selected sub-memory blocks may correspond to a memory block that is a unit of erase operation. For example, the two sub-memory blocks SMB11 and SMB21 may correspond to the first memory block and the two sub-memory blocks SMB12 and SMB22 may correspond to the second memory block. For convenience of illustration and description, an example is described in which the memory cell array includes two memory blocks, but the number of memory blocks may be varied.

Referring to FIGS. 21 and 22, the first and second block decoders BDEC1 and BDEC2 may generate block select signals to determine the one selected memory block among the first memory block SMB11 and SMB21 and the second memory block SMB12 and SMB22 based on the block address B_ADDR.

The first block decoder BDEC1 may generate a first block select signal BLKWL1 corresponding to the first memory block SMB11 and SMB21, and the second block decoder BDEC2 may generate a second block select signal BLKWL2 corresponding to the second memory block SMB12 and SMB22.

The first and second pass transistor blocks PTB1 and PTB2 may control the delivery of the plurality of drive signals SI to the corresponding memory blocks based on the block select signals provided by the corresponding block decoders.

The first pass transistor block PTB1 may control the delivery of the plurality of drive signals SI to the first memory blocks SMB11 and SMB21 based on the block select signal BLKWL1 provided from the first block decoder BDEC1. The second pass transistor block PTB2 may control the delivery of the plurality of drive signals SI to the second memory blocks SMB12 and SMB22 based on the block select signal BLKWL2 provided from the second block decoder BDEC2.

In the case of selecting the first memory blocks SMB11 and SMB21, the block select signal BLKWL1 provided from the first block decoder BDEC1 may be activated. Accordingly, all pass transistors PTR included in the first pass transistor block PTB1 are turned on. At this time, the plurality of drive signals SI including ground select signals GS, string select signals SS, and wordline drive signals S0 to S63, are delivered to the first memory blocks SMB11 and SMB21. The plurality of drive signals GS, SS, and S0 to S63 may be provided to each of the selection transistors of the first memory blocks SMB11 and SMB21 and the gates (i.e., wordlines) of the memory cells.

When the second memory block SMB12 and SMB22 is selected, the block select signal BLKWL2 provided from the second block decoder BDEC2 may be activated. Accordingly, all of the pass transistors PTR included in the second pass transistor block PTB2 are turned on. At this time, the plurality of drive signals SI including ground select signals GS, string select signals SS, and wordline drive signals S0 to S63 are delivered to the second memory blocks SMB12 and SMB22. The plurality of drive signals GS, SS, and S0 to S63 may be provided to each of the selection transistors of the second memory blocks SMB12 and SMB22 and the gates (i.e., wordlines) of the memory cells.

In this way, the plurality of wordline drive signals S0 to S63 generated based on the row address R_ADDR may be provided to the plurality of first wordlines of the first cell region CREG1 and the plurality of second wordlines of the second cell region CREG2.

In the DDWL structure described with reference to FIGS. 19 through 22, the sum of a first number of the plurality of first end bitlines NBLL in the first cell region CREG1 and a second number of the plurality of second end bitlines NBLU in the second cell region CREG2 is equal to the bit number of a page that is the unit of the read operation and the write operation. For example, if the bit number of a page that is the unit of the read operation and the write operation is 2N, the first number of the plurality of first normal bitlines NBLL and the second number of the plurality of second normal bitlines NBLU are N, respectively.

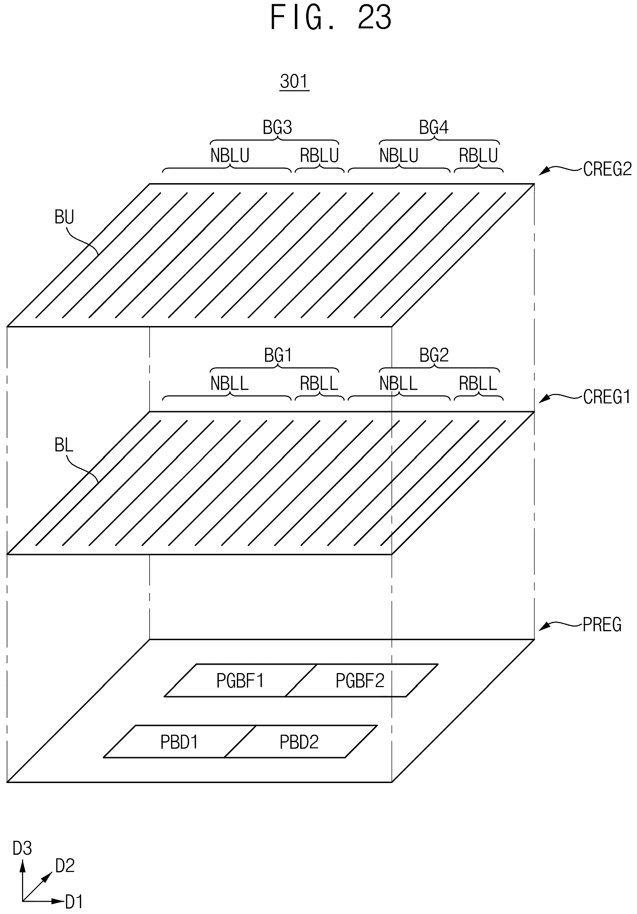

FIG. 23 is a perspective diagram illustrating an example of a nonvolatile memory device. Referring to FIG. 23, a nonvolatile memory device 301 may include a first cell region CREG1, a second cell region CREG2, and a peripheral circuit region PREG. In some implementations, the first cell region CREG1, the second cell region CREG2, and the peripheral circuit region PREG may be stacked in the vertical direction D3. For example, as shown in FIG. 23, the second cell region CREG2 may be disposed above the first cell region CREG1 in the vertical direction D3, and the peripheral circuit region PREG may be disposed below the first cell region CREG1 in the vertical direction D3.

For convenience of illustration and description, the case of stacking two cell regions CREG1 and CREG2 in the vertical direction D3 will be described, but arrangements within the scope of this disclosure are not limited thereto. For example, as will be described below with reference to FIG. 30, a nonvolatile memory device may include three or more stacked cell regions, and an integrated column repair may be applied to all of the stacked cell regions in the vertical direction.

The first cell region CREG1 may include a plurality of first bitlines BL and the second cell region CREG2 may include a plurality of second bitlines BU. The first bitlines BL of the first cell region CREG1 may include a plurality of first normal bitlines NBLL and a plurality of first redundant bitlines RBLL. The second bitlines BU of the second cell region CREG2 may include a plurality of second normal bitlines NBLU and a plurality of second redundant bitlines RBLU.

The first bitlines BL of the first cell region CREG1 may be grouped into a first bitline group BG1 including a portion of the plurality of first normal bitlines NBLL and a portion of the plurality of first redundant bitlines RBLL, and a second bitline group BG2 including the other portion of the plurality of first normal bitlines NBLL and the other portion of the plurality of first redundant bitlines RBLL.

The second bitlines BU of the second cell region CREG2 may be grouped into a third bitline group BG3, which includes a portion of the plurality of second normal bitlines NBLU and a portion of the plurality of second redundant bitlines RBLU, and a fourth bitline group BG4, which includes the other portion of the plurality of second normal bitlines NBLU and the other portion of the plurality of second redundant bitlines RBLU.

FIG. 23 illustrates, but is not limited to, the bitlines of each cell region being grouped into two bitline groups. For example, the bitlines of each cell region may be grouped into three or more bitline groups.

The page buffer circuit PGBF described above may include a first page buffer circuit PGBF1 and a second page buffer circuit PGBF2, and the page buffer decoder PBD described above may include a first page buffer decoder PBD 1 controlling the page buffers of the first page buffer circuit PGBF1 and a second page buffer decoder PBD2 controlling the page buffers of the second page buffer circuit PGBF2.

The first page buffer circuit PGBF1 may include page buffers associated with the first normal bitlines NBLL and first redundant bitlines RBLL of the first bitline group BG1 and the second normal bitlines NBLU and second redundant bitlines RBLU of the third bitline group BG3. The second page buffer circuit PGBF2 may include page buffers associated with the first normal bitline NBLL and the first redundant bitline RBLL of the second bitline group BG2 and the second normal bitline NBLU and the second redundant bitline RBLU of the fourth bitline group BG4.

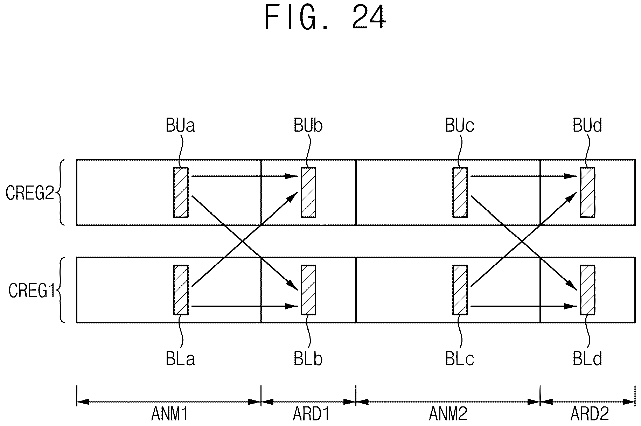

FIG. 24 is a diagram illustrating an example of integrated column repair of the nonvolatile memory device of FIG. 23.

In FIG. 24, normal regions ANM1 and ANM2 represent regions in which the normal bitlines are disposed, and redundant regions ARD1 and ARD2 represent regions in which the redundant bitlines are disposed.

Referring to FIG. 24, the first page buffer decoder PBD1 may integrate the defective bitlines occurring among the first normal bitlines NBLL of the first bitline group BG1 and the second normal bitlines NBLU of the third bitline group BG3 and replace the defective bitlines with the first redundant bitlines RBLL of the first bitline group BG1 and the second redundant bitlines RBLU of the third bitline group BG3. For example, the defective bitline BLa occurring among the first normal bitlines NBLL of the first bitline group BG1 of the first cell region CREG1 may be replaced by one of the first redundant bitlines BLb of the first bitline group BG1 and the second redundant bitlines BUb of the third bitline group BG3, and/or the defective bitline BUa occurring among the second normal bitlines NBLU of the third bitline group BG3 may be replaced by one of the first redundant bitline BLb of the first bitline group BG1 and the second redundant bitline BUb of the third bitline group BG3.

The second page buffer decoder PBD2 may integrate the defective bitlines occurring among the first normal bitlines NBLL of the second bitline group BG2 and the second normal bitlines NBLU of the fourth bitline group BG4 and replace the defective bitlines with the first redundant bitlines RBLL of the second bitline group BG2 and the second redundant bitlines RBLU of the fourth bitline group BG4. For example, the defective bitline BLc occurring among the first normal bitlines NBLL of the second bitline group BG2 of the first cell region CREG1 may be replaced by one of the first redundant bitlines BLd of the second bitline group BG2 and the second redundant bitlines BUd of the fourth bitline group BG4, and/or the defective bitline BUc occurring among the second normal bitline of the fourth bitline group BG4 may be replaced by one of the first redundant bitline BLd of the second bitline group BG2 and the second redundant bitline BUd of the fourth bitline group BG4.

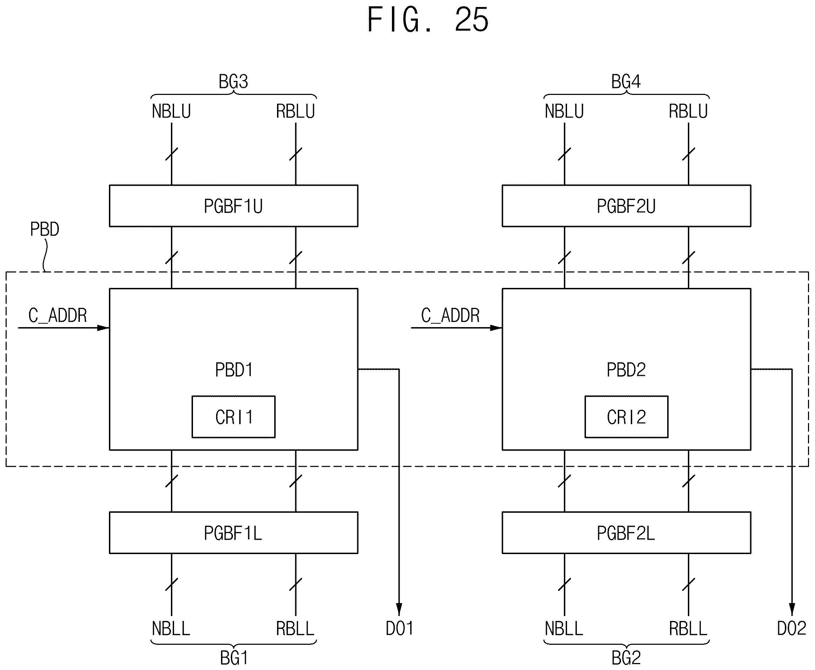

FIG. 25 is a block diagram illustrating an example of a page buffer circuit and a page buffer decoder included in the nonvolatile memory device of FIG. 23.

Referring to FIG. 25, the page buffer decoder PBD may include a first page buffer decoder PBD1 and a second page buffer decoder PBD2. The first page buffer decoder PBD1 may be connected to a page buffer circuit PGBF1L including page buffers connected to the first normal bitlines NBLL and the first redundant bitlines RBLL of the first bitline group BG1 and to a page buffer circuit PGBF1U including page buffers connected to the second normal bitlines NBLU and the second redundant bitlines RBLU of the third bitline group BG3. The two page buffer circuits PGBF1L and PGBF1U correspond to the first page buffer circuit PGBF1 of FIG. 23.

The second page buffer decoder PBD2 may be connected to a page buffer circuit PGBF2L including page buffers connected to the first normal bitlines NBLL and the first redundant bitlines RBLL of the second bitline group BG2 and to a page buffer circuit PGBF2U including page buffers connected to the second normal bitlines NBLU and the second redundant bitlines RBLU of the fourth bitline group BG4. The two page buffer circuits PGBF2L and PGBF2U correspond to the second page buffer circuit PGBF2 of FIG. 23.

In some implementations, each of the first page buffer decoder PBD1 and the second page buffer decoder PBD2 may include a control logic circuit CLG, a first switch circuit SW1, a second switch circuit SW2, and a third switch circuit SW3 as described with reference to FIG. 5.

The first page buffer decoder PBD1 may output a data output signal DO1 by performing an integrated column repair for the first bitline group BG1 of the first cell region CREG1 and the third bitline group BG3 of the second cell region CREG2 based on the column address C_ADDR and first column repair information CRI1 that is stored in the first page buffer decoder PBD1. The first column repair information CRI1 may include integrated information on the defective bitlines occurring among the first normal bitlines NBLL of the first bitline group BG1 and the defective bitlines occurring among the second normal bitlines NBLU of the third bitline group BG3.

The second page buffer decoder PBD2 may output a data output signal DO2 by performing an integrated column repair for the second bitline group BG2 of the first cell region CREG1 and the fourth bitline group BG4 of the second cell region CREG2 based on the column address C_ADDR and second column repair information CRI2 that is stored in the second page buffer decoder PBD2. The second column repair information CRI2 may include integrated information on the defective bitlines occurring among the first normal bitlines NBLL of the second bitline group BG2 and the defective bitlines occurring among the second normal bitlines NBLU of the fourth bitline group BG4.

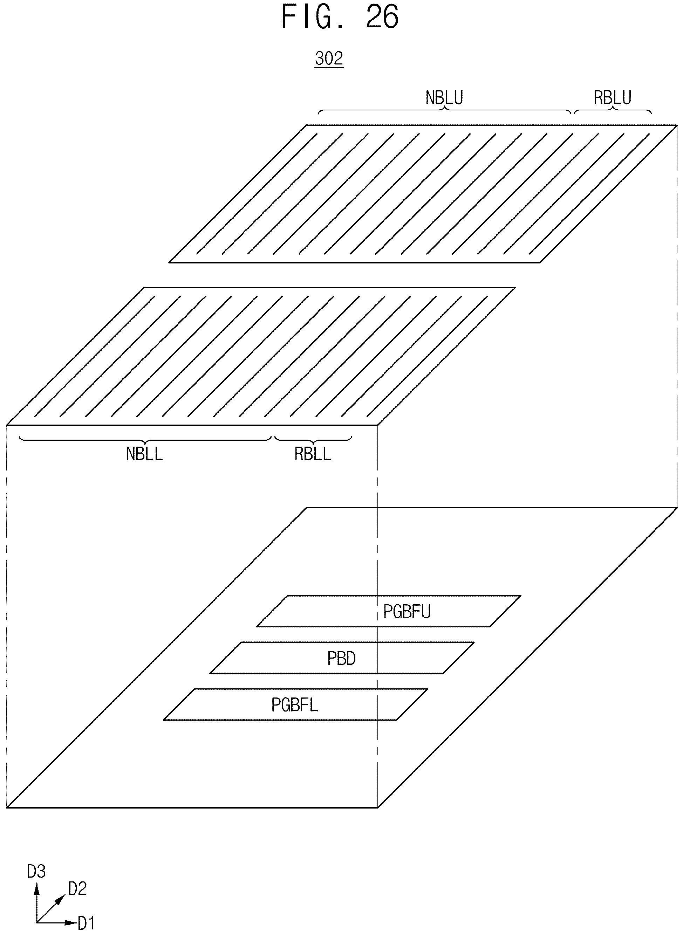

FIG. 26 is a perspective diagram illustrating an example of a nonvolatile memory device.

Referring to FIG. 26, a nonvolatile memory device 302 may include a first cell region CREG1, a second cell region CREG2, and a peripheral circuit region PREG. Hereinafter, description that is redundant to FIG. 1 will be omitted.

As shown in FIG. 26, the first cell region CREG1 and the second cell region CREG2 may be disposed above the peripheral circuit region PREG in the vertical direction D3. The plurality of first normal bitlines NBLL, the plurality of first redundant bitlines RBLL, the plurality of second normal bitlines NBLU, and the plurality of second redundant bitlines RBLU may be arranged in the first horizontal direction D1 and extend in the second horizontal direction D2 perpendicular to the first horizontal direction D1. The first cell region CREG1 and the second cell region CREG2 may be arranged in the second horizontal direction D2.

As described above, the page buffer decoder PBD may be formed extending in the first horizontal direction D1. A first page buffer circuit PGBFL including page buffers connected to the first normal bitlines NBLL and the first redundant bitlines RBLL may be disposed adjacent to the first side in the second horizontal direction D2 of the page buffer decoder PBD. A second page buffer circuit PGBFU including page buffers connected to the second normal bitlines NBLU and the second redundant bitlines RBLU may be disposed adjacent to the second side in the second horizontal direction D2 of the page buffer decoder PBD.

The page buffer decoder PBD may perform an integrated column repair that integrates and replaces defective bitlines occurring from the plurality of first normal bitlines NBLL and the plurality of second normal bitlines NBLU with the plurality of first redundant bitlines RBLL and the plurality of second redundant bitlines RBLU.

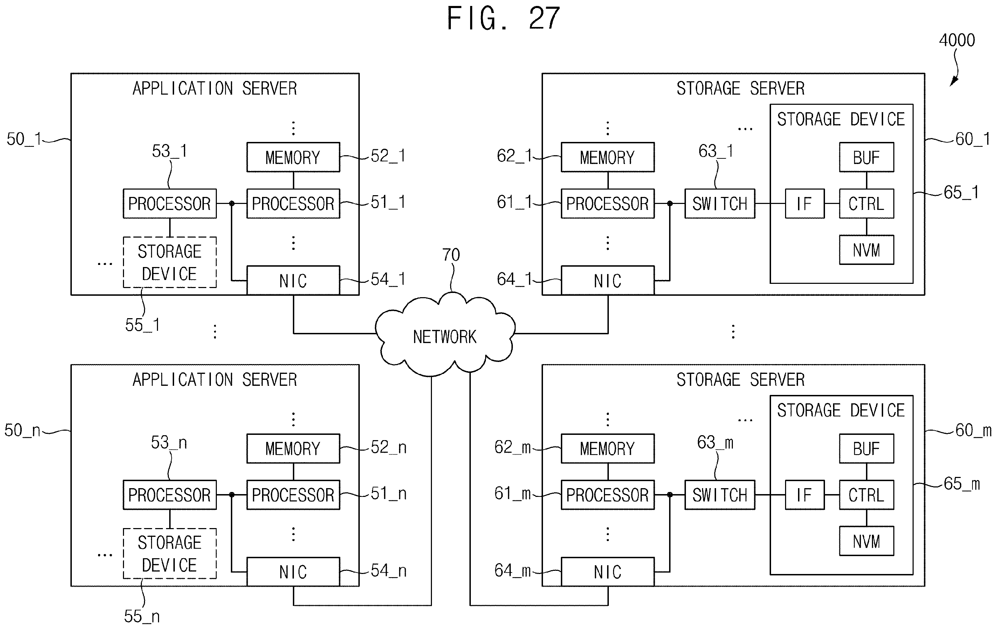

FIG. 27 is a block diagram illustrating an example of a data center including a storage device. In some implementations, at least one NVM of FIG. 27 has a structure as described with respect to FIGS. 1-26.

Referring to FIG. 27, the data center 4000 may collect various pieces of data and provide services and be also referred to as a data storage center. For example, the data center 4000 may be a system configured to operate a search engine and a database or a computing system used by companies, such as banks, or government agencies. As shown in FIG. 27, the data center 4000 may include application servers 50_1 to 50_n and storage servers 60_1 to 60_m (where, each of m and n is an integer more than 1). The number n of application servers 50_1 to 50_n and the number m of storage servers 60_1 to 60_m may be variously selected. In some implementations, the number n of application servers 50_1 to 50_n may be different from the number m of storage servers 60_1 to 60_m.

The application servers 50_1 to 50_n may include any one or any combination of processors 51_1 to 5 1_n, memories 52_1 to 52_n, switches 53_1 to 53_n, network interface controllers (NICs) 54_1 to 54_n, and storage devices 55_1 to 55_n. The processors 51_1 to 51_n may control all operations of the application servers 50_1 to 50_n, access the memories 52_1 to 52_n, and execute instructions and/or data loaded in the memories 52_1 to 52_n. Non-limiting examples of the memories 52_1 to 52_n may include DDR SDRAM, a high-bandwidth memory (HBM), a hybrid memory cube (HMC), a dual in-line memory module (DIMM), a Optane DIMM, or a nonvolatile DIMM (NVDIIMM).

The numbers of processors and memories included in the application servers 50_1 to 50_n may be variously selected. In some implementations, the processors 51_1 to 51_n and the memories 52_1 to 52_n may provide processor-memory pairs. In some implementations, the number of processors 51_1 to 51_n may be different from the number of memories 52_1 to 52_n. The processors 51_1 to 51_n may include a single core processor or a multi-core processor. In some implementations, as illustrated with a dashed line in FIG. 27, the storage devices 55_1 to 55_n may be omitted from the application servers 50_1 to 50_n. The number of storage devices 55_1 to 55_n included in the application servers 50_1 to 50_n may be variously selected. The processors 51_1 to 51_n, the memories 52_1 to 52_n, the switches 53_1 to 53_n, the NICs 54_1 to 54_n, and/or the storage devices 55_1 to 55_n may communicate with each other through a link described above with reference to the drawings.

The storage servers 60_1 to 60_m may include any one or any combination of processors 61_1 to 61_m, memories 62_1 to 62_m, switches 63_1 to 63_m, network interface controllers (NICs) 64_1 to 64_n, and storage devices 65_1 to 65_m. The processors 61_1 to 61_m and the memories 62_1 to 62_m may operate similar to the processors 51_1 to 51_n and the memories 52_1 to 52_n of the application servers 50_1 to 50_n described above.

The application servers 50_1 to 50_n may communicate with the storage servers 60_1 to 60_m through a network 70. In some implementations, the network 70 may be implemented using a fiber channel (FC) or Ethernet. The FC may be a medium used for relatively high-speed data transfer. An optical switch that provides high performance and high availability may be used as the FC. The storage servers 60_1 to 60_m may be provided as file storages, block storages, or object storages according to an access method of the network 70.

In some implementations, the network 70 may be a storage-only network, such as a storage area network (SAN). For example, the SAN may be an FC-SAN, which may use an FC network and be implemented using an FC Protocol (FCP). In another case, the SAN may be an Internet protocol (IP)-SAN, which uses a transmission control protocol/Internet protocol (TCP/IP) network and is implemented according to an SCSI over TCP/IP or Internet SCSI (iSCSI) protocol. In some implementations, the network 70 may be a general network, such as a TCP/IP network. For example, the network 70 may be implemented according to a protocol, such as FC over Ethernet (FCoE), network attached storage (NAS), nonvolatile memory express (NVMe) over fabrics (NVMe-oF).

The application server 50_1 and the storage server 60_1 will mainly be described, but it may be noted that a description of the application server 50_1 may be also applied to another application server (e.g., 50_n), and a description of the storage server 60_1 may be also applied to another storage server (e.g., 60_m).

The application server 50_1 may store data, which is requested to be stored by a user or a client, in one of the storage servers 60_1 to 60_m through the network 70. In some implementations, the application server 50_1 may obtain data, which is requested to be read by the user or the client, from one of the storage servers 60_1 to 60_m through the network 70. For example, the application server 50_1 may be implemented using a web server or a database management system (DBMS).

The application server 50_1 may access the memory 52_n and/or the storage device 55_n included in another application server 50_n, through the network 70, and/or access the memories 62_1 to 62_m and/or the storage devices 65_1 to 65_m included in the storage servers 60_1 to 60_m, through the network 70. Accordingly, the application server 50_1 may perform various operations on data stored in the application servers 50_1 to 50_n and/or the storage servers 60_1 to 60_m. For example, the application server 50_1 may execute an instruction to migrate or copy data between the application servers 50_1 to 50_n and/or the storage servers 60_1 to 60_m. In this case, the data may be migrated from the storage devices 65_1 to 65_m of the storage servers 60_1 to 60_m to the memories 52_1 to 52_n of the application servers 50_1 to 50_n through the memories 62_1 to 62_m of the storage servers 60_1 to 60_m or directly. In some implementations, the data migrated through the network 70 may be encrypted data for security or privacy.

In the storage server 60_1, an interface IF may provide physical connection between the processor 61_1 and a controller CTRL and physical connection between the NIC 64_1 and the controller CTRL. For example, the interface IF may be implemented using a direct attached storage (DAS) method in which the storage device 65_1 is directly connected to a dedicated cable. For example, the interface IF may be implemented using various interface methods, such as advanced technology attachment (ATA), serial ATA (SATA), external SATA (e-SATA), small computer small interface (SCSI), serial attached SCSI (SAS), PCI, PCIe, NVMe, IEEE 1394, a universal serial bus (USB), a secure digital (SD) card, a multi-media card (MMC), an embedded MMC (eMMC), a UFS, an embedded UFS (eUFS), and/or a compact flash (CF) card interface.

In the storage server 60_1, the switch 63_1 may selectively connect the processor 61_1 to the storage device 65_1 or selectively connect the NIC 64_1 to the storage device 65_1 based on the control of the processor 61_1.

In some implementations, the network interface controller (NIC) 64_1 may include a network interface card and a network adaptor. The NIC 54_1 may be connected to the network 70 through a wired interface, a wireless interface, a Bluetooth interface, or an optical interface. The NIC 54_1 may include an internal memory, a digital signal processor (DSP), and a host bus interface and be connected to the processor 61_1 and/or the switch 63_1 through the host bus interface. In some implementations, the NIC 64_1 may be integrated with any one or any combination of the processor 61_1, the switch 63_1, and the storage device 65_1.

In the application servers 50_1 to 50_n or the storage servers 60_1 to 60_m, the processors 51_1 to 51_m and 61_1 to 61_n may transmit commands to the storage devices 55_1 to 55_n and 65_1 to 65_m or the memories 52_1 to 52_n and 62_1 to 62_m and program or read data. In this case, the data may be data of which an error is corrected by an error correction code (ECC) engine. The data may be data processed with data bus inversion (DBI) or data masking (DM) and include cyclic redundancy Code (CRC) information. The data may be encrypted data for security or privacy.

In response to read commands received from the processors 51_1 to 51_m and 61_1 to 61_n, the storage devices 55_1 to 55_n and 65_1 to 65_m may transmit control signals and command/address signals to a nonvolatile memory device (e.g., a NAND flash memory device) NVM. Accordingly, when data is read from the nonvolatile memory device NVM, a read enable signal may be input as a data output control signal to output the data to a DQ bus. A data strobe signal may be generated using the read enable signal. The command and the address signal may be latched according to a rising edge or falling edge of a write enable signal.

The controller CTRL may control all operations of the storage device 65_1. In some implementations, the controller CTRL may include static RAM (SRAM). The controller CTRL may write data to the nonvolatile memory device NVM in response to a write command or read data from the nonvolatile memory device NVM in response to a read command. For example, the write command and/or the read command may be generated based on a request provided from a host (e.g., the processor 61_1 of the storage server 60_1, the processor 61_m of another storage server 60_m, or the processors 51_1 to 51_n of the application servers 50_1 to 50_n). A buffer BUF may temporarily store (or buffer) data to be written to the nonvolatile memory device NVM or data read from the nonvolatile memory device NVM. In some implementations, the buffer BUF may include DRAM. The buffer BUF may store metadata. The metadata may refer to user data or data generated by the controller CTRL to manage the nonvolatile memory device NVM. The storage device 65_1 may include a secure element (SE) for security or privacy.

FIG. 28 is a cross-sectional diagram illustrating an example of a nonvolatile memory device.

Referring to FIG. 28, the memory device 5000 may have a chip-to-chip (C2C) structure. At least one upper chip including a cell region and a lower chip including a peripheral circuit region PREG may be manufactured separately, and then, the at least one upper chip and the lower chip may be connected to each other by a bonding method to realize the C2C structure. For example, the bonding method may refer to a method of electrically and/or physically connecting a bonding metal pattern formed in an uppermost metal layer of the upper chip to a bonding metal pattern formed in an uppermost metal layer of the lower chip. For example, in a case in which the bonding metal patterns are formed of copper CU, the bonding method may be a Cu-Cu bonding method. Alternatively or additionally, the bonding metal patterns may be formed of other metals including, but not being limited to, aluminum (Al) or tungsten (W).

The memory device 5000 may include the at least one upper chip including the cell region. For example, as shown in FIG. 28, the memory device 5000 may include two upper chips. However, the number of the upper chips is not limited thereto. In the case in which the memory device 5000 includes the two upper chips, a first upper chip that may include a first cell region CREG1, a second upper chip that may include a second cell region CREG2 and the lower chip that may include the peripheral circuit region PREG, may be manufactured separately. Subsequently, the first upper chip, the second upper chip and the lower chip may be connected to each other by the bonding method to manufacture the memory device 5000, for example. In some implementations, the first upper chip may be turned over and then may be connected to the lower chip by the bonding method, and the second upper chip may also be turned over and then may be connected to the first upper chip by the bonding method. Hereinafter, upper and lower portions of each of the first and second upper chips will be defined based on before each of the first and second upper chips is turned over. For example, an upper portion of the lower chip may mean an upper portion defined based on a +Z-axis direction, and the upper portion of each of the first and second upper chips may mean an upper portion defined based on a -Z-axis direction in FIG. 28. However, configurations are not limited in this regard. For example, in some implementations, one of the first upper chip and the second upper chip may be turned over and then may be connected to a corresponding chip by the bonding method.

Each of the peripheral circuit region PREG and the first and second cell regions CREG1 and CREG2 of the memory device 5000 may include an external pad bonding region PA, a wordline bonding region WLBA, and a bitline bonding region BLBA.

The peripheral circuit region PREG may include a first substrate 5210 and a plurality of circuit elements (e.g., first circuit element 5220a, second circuit element 5220b, and third circuit element 5220c) formed on the first substrate 5210. An interlayer insulating layer 5215 including one or more insulating layers may be provided on the plurality of circuit elements 5220a, 5220b and 5220c, and a plurality of metal lines electrically connected to the plurality of circuit elements 5220a, 5220b and 5220c may be provided in the interlayer insulating layer 5215. For example, the plurality of metal lines may include first metal lines 5230a, 5230b and 5230c connected to the plurality of circuit elements 5220a, 5220b and 5220c, and second metal lines 5240a, 5240b and 5240c formed on the first metal lines 5230a, 5230b and 5230c. The plurality of metal lines may be formed of at least one of various conductive materials. In some implementations, the first metal lines 5230a, 5230b and 5230c may be formed of tungsten having a relatively high electrical resistivity, and the second metal lines 5240a, 5240b and 5240c may be formed of copper having a relatively low electrical resistivity.

The first metal lines 5230a, 5230b and 5230c and the second metal lines 5240a, 5240b and 5240c are illustrated and described. However, implementations are not limited in this regard. For example, in some implementations, at least one or more additional metal lines may further be formed on the second metal lines 5240a, 5240b and 5240c. In this case, the second metal lines 5240a, 5240b and 5240c may be formed of aluminum, and at least some of the additional metal lines formed on the second metal lines 5240a, 5240b and 5240c may be formed of copper having an electrical resistivity lower than that of aluminum of the second metal lines 5240a, 5240b and 5240c.

The interlayer insulating layer 5215 may be disposed on the first substrate 5210 and may include an insulating material such as silicon oxide and/or silicon nitride.

Each of the first and second cell regions CREG1 and CREG2 may include at least one memory block. The first cell region CREG1 may include a second substrate 5310 and a common source line 5320. A plurality of wordlines 5330 (e.g., 5331 to 5338) may be stacked on the second substrate 5310 in a direction (e.g., the Z-axis direction) perpendicular to a top surface of the second substrate 5310. String selection lines and a ground selection line may be disposed on and under the wordlines 5330, and the plurality of wordlines 5330 may be disposed between the string selection lines and the ground selection line. Alternatively or additionally, the second cell region CREG2 may include a third substrate 5410 and a common source line 5420, and a plurality of wordlines 5430 (e.g., 5431 to 5438) may be stacked on the third substrate 5410 in a direction (e.g., the Z-axis direction) perpendicular to a top surface of the third substrate 5410. Each of the second substrate 5310 and the third substrate 5410 may be formed of at least one of various materials, such as, but not limited to, a silicon substrate, a silicon-germanium substrate, a germanium substrate, or a substrate having a single-crystalline epitaxial layer grown on a single-crystalline silicon substrate. A plurality of channel structures CH may be formed in each of the first and second cell regions CREG1 and CREG2.

In some implementations, as illustrated in a region 'A1', the channel structure CH may be provided in the bitline bonding region BLBA and may extend in the direction perpendicular to the top surface of the second substrate 5310 to penetrate the wordlines 5330, the string selection lines, and the ground selection line. The channel structure CH may include a data storage layer, a channel layer, and a filling insulation layer. The channel layer may be electrically connected to a first metal line 5350c and a second metal line 5360c in the bitline bonding region BLBA. For example, the second metal line 5360c may be a bitline and may be connected to the channel structure CH through the first metal line 5350c. The bitline 5360c may extend in a first direction (e.g., a Y-axis direction) parallel to the top surface of the second substrate 5310.

In some implementations, as illustrated in a region 'A2', the channel structure CH may include a lower channel LCH and an upper channel UCH, which may be connected to each other. For example, the channel structure CH may be formed by a process of forming the lower channel LCH and a process of forming the upper channel UCH. The lower channel LCH may extend in the direction perpendicular to the top surface of the second substrate 5310 to penetrate the common source line 5320 and lower wordlines 5331 and 5332. The lower channel LCH may include a data storage layer, a channel layer, and a filling insulation layer and may be connected to the upper channel UCH. The upper channel UCH may penetrate upper wordlines 5333 to 5338. The upper channel UCH may include a data storage layer, a channel layer, and a filling insulation layer, and the channel layer of the upper channel UCH may be electrically connected to the first metal line 5350c and the second metal line 5360c. As a length of a channel increases, due to characteristics of manufacturing processes, it may be difficult to form a channel having a substantially uniform width. The memory device 5000 may include a channel having improved width uniformity due to the lower channel LCH and the upper channel UCH which are formed by the processes performed sequentially.

In the case in which the channel structure CH includes the lower channel LCH and the upper channel UCH as illustrated in the region 'A2', a wordline located near to a boundary between the lower channel LCH and the upper channel UCH may be a dummy wordline. For example, the wordlines 5332 and 5333 adjacent to the boundary between the lower channel LCH and the upper channel UCH may be the dummy wordlines. In this case, data may not be stored in memory cells connected to the dummy wordline. Alternatively or additionally, the number of pages corresponding to the memory cells connected to the dummy wordline may be less than the number of pages corresponding to the memory cells connected to a general wordline. A level of a voltage applied to the dummy wordline may be different from a level of a voltage applied to the general wordline, and thus, it may be possible to reduce an influence of a non-uniform channel width between the lower and upper channels LCH and UCH on an operation of the memory device.

In some implementations, the number of the lower wordlines 5331 and 5332 penetrated by the lower channel LCH may be less than the number of the upper wordlines 5333 to 5338 penetrated by the upper channel UCH in the region 'A2'. However, the wordline configuration is not limited in this regard. For example, in some implementations, the number of the lower wordlines penetrated by the lower channel LCH may be equal to or more than the number of the upper wordlines penetrated by the upper channel UCH. Alternatively or additionally, structural features and connection relation of the channel structure CH disposed in the second cell region CREG2 may be substantially the same as those of the channel structure CH disposed in the first cell region CREG1.

In the bitline bonding region BLBA, a first through-electrode THV1 may be provided in the first cell region CREG1, and a second through-electrode THV2 may be provided in the second cell region CREG2. As illustrated in FIG. 28, the first through-electrode THV1 may penetrate the common source line 5320 and the plurality of wordlines 5330. In some implementations, the first through-electrode THV1 may further penetrate the second substrate 5310. The first through-electrode THV1 may include a conductive material. Alternatively or additionally, the first through-electrode THV1 may include a conductive material surrounded by an insulating material. The second through-electrode THV2 may have the same shape and structure as the first through-electrode THV1.

In some implementations, the first through-electrode THV1 and the second through-electrode THV2 may be electrically connected to each other through a first through-metal pattern 5372d and a second through-metal pattern 5472d. The first through-metal pattern 5372d may be formed at a bottom end of the first upper chip including the first cell region CREG1, and the second through-metal pattern 5472d may be formed at a top end of the second upper chip including the second cell region CREG2. The first through-electrode THV1 may be electrically connected to the first metal line 5350c and the second metal line 5360c. A lower via 5371d may be formed between the first through-electrode THV1 and the first through-metal pattern 5372d, and an upper via 5471d may be formed between the second through-electrode THV2 and the second through-metal pattern 5472d. The first through-metal pattern 5372d and the second through-metal pattern 5472d may be connected to each other by the bonding method.

In some implementations, in the bitline bonding region BLBA, an upper metal pattern 5252 may be formed in an uppermost metal layer of the peripheral circuit region PREG, and an upper metal pattern 5392 having the same shape as the upper metal pattern 5252 may be formed in an uppermost metal layer of the first cell region CREG1. The upper metal pattern 5392 of the first cell region CREG1 and the upper metal pattern 5252 of the peripheral circuit region PREG may be electrically connected to each other by the bonding method. In the bitline bonding region BLBA, the bitline 5360c may be electrically connected to a page buffer included in the peripheral circuit region PREG. For example, some of the circuit elements 5220c of the peripheral circuit region PREG may constitute the page buffer, and the bitline 5360c may be electrically connected to the circuit elements 5220c constituting the page buffer through an upper bonding metal pattern 5370c of the first cell region CREG1 and an upper bonding metal pattern 5270c of the peripheral circuit region PREG.

Continuing to refer to FIG. 28, in the wordline bonding region WLBA, the wordlines 5330 of the first cell region CREG1 may extend in a second direction (e.g., an X-axis direction) parallel to the top surface of the second substrate 5310 and may be connected to a plurality of cell contact plugs 5340 (e.g., 5341 to 5347). First metal lines 5350b and second metal lines 5360b may be sequentially connected onto the cell contact plugs 5340 connected to the wordlines 5330. In the wordline bonding region WLBA, the cell contact plugs 5340 may be connected to the peripheral circuit region PREG through upper bonding metal patterns 5370b of the first cell region CREG1 and upper bonding metal patterns 5270b of the peripheral circuit region PREG.

The cell contact plugs 5340 may be electrically connected to a row decoder included in the peripheral circuit region PREG. For example, some of the circuit elements 5220b of the peripheral circuit region PREG may constitute the row decoder, and the cell contact plugs 5340 may be electrically connected to the circuit elements 5220b constituting the row decoder through the upper bonding metal patterns 5370b of the first cell region CREG1 and the upper bonding metal patterns 5270b of the peripheral circuit region PREG. In some implementations, an operating voltage of the circuit elements 5220b constituting the row decoder may be different from an operating voltage of the circuit elements 5220c constituting the page buffer. For example, the operating voltage of the circuit elements 5220c constituting the page buffer may be greater than the operating voltage of the circuit elements 5220b constituting the row decoder.

In some implementations, in the wordline bonding region WLBA, the wordlines 5430 of the second cell region CREG2 may extend in the second direction (e.g., the X-axis direction) parallel to the top surface of the third substrate 5410 and may be connected to a plurality of cell contact plugs 5440 (e.g., 5441 to 5447). The cell contact plugs 5440 may be connected to the peripheral circuit region PREG through an upper metal pattern of the second cell region CREG2 and lower and upper metal patterns and a cell contact plug 5348 of the first cell region CREG1.

In the wordline bonding region WLBA, the upper bonding metal patterns 5370b may be formed in the first cell region CREG1, and the upper bonding metal patterns 5270b may be formed in the peripheral circuit region PREG. The upper bonding metal patterns 5370b of the first cell region CREG1 and the upper bonding metal patterns 5270b of the peripheral circuit region PREG may be electrically connected to each other by the bonding method. The upper bonding metal patterns 5370b and the upper bonding metal patterns 5270b may be formed of at least one metal including, but not limited to, aluminum, copper, and tungsten.

In the external pad bonding region PA, a lower metal pattern 5371e may be formed in a lower portion of the first cell region CREG1, and an upper metal pattern 5472a may be formed in an upper portion of the second cell region CREG2. The lower metal pattern 5371e of the first cell region CREG1 and the upper metal pattern 5472a of the second cell region CREG2 may be connected to each other by the bonding method in the external pad bonding region PA. In some implementations, an upper metal pattern 5372a may be formed in an upper portion of the first cell region CREG1, and an upper metal pattern 5272a may be formed in an upper portion of the peripheral circuit region PREG. The upper metal pattern 5372a of the first cell region CREG1 and the upper metal pattern 5272a of the peripheral circuit region PREG may be connected to each other by the bonding method.

Common source line contact plugs 5380 and 5480 may be disposed in the external pad bonding region PA. The common source line contact plugs 5380 and 5480 may be formed of a conductive material such as a metal, a metal compound, and/or doped polysilicon. The common source line contact plug 5380 of the first cell region CREG1 may be electrically connected to the common source line 5320, and the common source line contact plug 5480 of the second cell region CREG2 may be electrically connected to the common source line 5420. A first metal line 5350a and a second metal line 5360a may be sequentially stacked on the common source line contact plug 5380 of the first cell region CREG1, and a first metal line 5450a and a second metal line 5460a may be sequentially stacked on the common source line contact plug 5480 of the second cell region CREG2.

Input-output pads 5205, 5405 and 5406 may be disposed in the external pad bonding region PA. As shown in FIG. 28, a lower insulating layer 5201 may cover a bottom surface of the first substrate 5210, and a first input-output pad 5205 may be formed on the lower insulating layer 5201. The first input-output pad 5205 may be connected to at least one of a plurality of the circuit elements 5220a disposed in the peripheral circuit region PREG through a first input-output contact plug 5203 and may be separated from the first substrate 5210 by the lower insulating layer 5201. Alternatively or additionally, a side insulating layer may be disposed between the first input-output contact plug 5203 and the first substrate 5210 to electrically isolate the first input-output contact plug 5203 from the first substrate 5210.

An upper insulating layer 5401 covering a top surface of the third substrate 5410 may be formed on the third substrate 5410. A second input-output pad 5405 and/or a third input-output pad 5406 may be disposed on the upper insulating layer 5401. The second input-output pad 5405 may be connected to at least one of the plurality of circuit elements 5220a disposed in the peripheral circuit region PREG through second input-output contact plugs 5403 and 5303, and the third input-output pad 5406 may be connected to at least one of the plurality of circuit elements 5220a disposed in the peripheral circuit region PREG through third input-output contact plugs 5404 and 5304.

In some implementations, the third substrate 5410 may not be disposed in a region in which the input-output contact plug is disposed. For example, as illustrated in a region 'B', the third input-output contact plug 5404 may be separated from the third substrate 5410 in a direction parallel to the top surface of the third substrate 5410 and may penetrate an interlayer insulating layer 5415 of the second cell region CREG2 so as to be connected to the third input-output pad 5406. In this case, the third input-output contact plug 5404 may be formed by at least one of various processes.

In some implementations, as illustrated in a region 'B1', the third input-output contact plug 5404 may extend in a third direction (e.g., the Z-axis direction), and a diameter of the third input-output contact plug 5404 may become progressively greater (e.g., wider) toward the upper insulating layer 5401. In other words, a diameter of the channel structure CH described in the region 'A1' may become progressively less (e.g., narrower) toward the upper insulating layer 5401, but the diameter of the third input-output contact plug 5404 may become progressively greater toward the upper insulating layer 5401. For example, the third input-output contact plug 5404 may be formed after the second cell region CREG2 and the first cell region CREG1 are bonded to each other by the bonding method.

In some implementations, as illustrated in a region 'B2', the third input-output contact plug 5404 may extend in the third direction (e.g., the Z-axis direction), and a diameter of the third input-output contact plug 5404 may become progressively less (e.g., narrower) toward the upper insulating layer 5401. In other words, like the channel structure CH, the diameter of the third input-output contact plug 5404 may become progressively less (e.g., narrower) toward the upper insulating layer 5401. For example, the third input-output contact plug 5404 may be formed together with the cell contact plugs 5440 before the second cell region CREG2 and the first cell region CREG1 are bonded to each other.

In some implementations, the input-output contact plug may overlap with the third substrate 5410. For example, as illustrated in a region 'C', the second input-output contact plug 5403 may penetrate the interlayer insulating layer 5415 of the second cell region CREG2 in the third direction (e.g., the Z-axis direction) and may be electrically connected to the second input-output pad 5405 through the third substrate 5410. In this case, a connection structure of the second input-output contact plug 5403 and the second input-output pad 5405 may be realized by various methods.

In some implementations, as illustrated in a region 'C1', an opening 5408 may be formed to penetrate the third substrate 5410, and the second input-output contact plug 5403 may be connected directly to the second input-output pad 5405 through the opening 5408 formed in the third substrate 5410. In this case, as illustrated in the region 'C1', a diameter of the second input-output contact plug 5403 may become progressively greater (e.g., wider) toward the second input-output pad 5405. However, dimensions are not limited in this regard. For example, in some implementations, the diameter of the second input-output contact plug 5403 may become progressively less (e.g., narrower) toward the second input-output pad 5405.

In some implementations, as illustrated in a region 'C2', the opening 5408 penetrating the third substrate 5410 may be formed, and a contact 5407 may be formed in the opening 5408. An end of the contact 5407 may be connected to the second input-output pad 5405, and another end of the contact 5407 may be connected to the second input-output contact plug 5403. Thus, the second input-output contact plug 5403 may be electrically connected to the second input-output pad 5405 through the contact 5407 in the opening 5408. In this case, as illustrated in the region 'C2', a diameter of the contact 5407 may become progressively greater (e.g., wider) toward the second input-output pad 5405, and a diameter of the second input-output contact plug 5403 may become progressively less (e.g., narrower) toward the second input-output pad 5405. For example, the second input-output contact plug 5403 may be formed together with the cell contact plugs 5440 before the second cell region CREG2 and the first cell region CREG1 are bonded to each other, and the contact 5407 may be formed after the second cell region CREG2 and the first cell region CREG1 are bonded to each other.

In some implementations illustrated in a region 'C3', a stopper 5409 may further be formed on a bottom end of the opening 5408 of the third substrate 5410, as compared with the region 'C2'. The stopper 5409 may be a metal line formed in the same layer as the common source line 5420. Alternatively or additionally, the stopper 5409 may be a metal line formed in the same layer as at least one of the wordlines 5430. The second input-output contact plug 5403 may be electrically connected to the second input-output pad 5405 through the contact 5407 and the stopper 5409.

Similar to the second and third input-output contact plugs 5403 and 5404 of the second cell region CREG2, a diameter of each of the second and third input-output contact plugs 5303 and 5304 of the first cell region CREG1 may become progressively less (e.g., narrower) toward the lower metal pattern 5371e and/or may become progressively greater (e.g., wider) toward the lower metal pattern 5371e.

In some implementations, a slit 5411 may be formed in the third substrate 5410. For example, the slit 5411 may be formed at a certain position of the external pad bonding region PA. For example, as illustrated in a region 'D', the slit 5411 may be located between the second input-output pad 5405 and the cell contact plugs 5440 when viewed in a plan view. Alternatively or additionally, the second input-output pad 5405 may be located between the slit 5411 and the cell contact plugs 5440 when viewed in a plan view.

In some implementations, as illustrated in a region 'D1', the slit 5411 may be formed to penetrate the third substrate 5410. For example, the slit 5411 may be used to prevent the third substrate 5410 from being finely cracked when the opening 5408 is formed. However, implementations are not limited in this regard. For example, in some implementations, the slit 5411 may be formed to have a depth ranging from about 60% to about 70% of a thickness of the third substrate 5410.

In some implementations, as illustrated in a region 'D2', a conductive material 5412 may be formed in the slit 5411. For example, the conductive material 5412 may be used to discharge a leakage current occurring in driving of the circuit elements in the external pad bonding region PA to the outside. In this case, the conductive material 5412 may be connected to an external ground line.

In some implementations, as illustrated in a region 'D3', an insulating material 5413 may be formed in the slit 5411. For example, the insulating material 5413 may be used to electrically isolate the second input-output pad 5405 and the second input-output contact plug 5403 disposed in the external pad bonding region PA from the wordline bonding region WLBA. Since the insulating material 5413 is formed in the slit 5411, it may be possible to prevent a voltage provided through the second input-output pad 5405 from affecting a metal layer disposed on the third substrate 5410 in the wordline bonding region WLBA.

In some implementations, the first to third input-output pads 5205, 5405 and 5406 may be selectively formed. For example, the memory device 5000 may be realized to include only the first input-output pad 5205 disposed on the first substrate 5210, to include only the second input-output pad 5405 disposed on the third substrate 5410, and/or to include only the third input-output pad 5406 disposed on the upper insulating layer 5401.

In some implementations, at least one of the second substrate 5310 of the first cell region CREG1 and the third substrate 5410 of the second cell region CREG2 may be used as a sacrificial substrate and may be completely and/or partially removed before and/or after a bonding process. An additional layer may be stacked after the removal of the substrate. For example, the second substrate 5310 of the first cell region CREG1 may be removed before and/or after the bonding process of the peripheral circuit region PREG and the first cell region CREG1. Subsequently, an insulating layer covering a top surface of the common source line 5320 or a conduction layer for connection may be formed. Similarly, the third substrate 5410 of the second cell region CREG2 may be removed before and/or after the bonding process of the first cell region CREG1 and the second cell region CREG2, and subsequently, the upper insulating layer 5401 covering a top surface of the common source line 5420 or a conduction layer for connection may be formed.

FIG. 29 is a diagram for describing examples of manufacturing processes of a nonvolatile memory device.

Referring to FIG. 29, respective integrated circuits may be formed on a first wafer WF1, a second wafer WF2, and a third wafer WF3. A memory cell array including the first cell region CREG1 and the second cell region CREG2 described above may be formed on the first wafer WF1 and the second wafer WF2, and peripheral circuits may be formed on the third wafer WF3. With the integrated circuits formed on the first wafer WF1, the second wafer WF2, and the third wafer WF3, the first wafer WF1, the second wafer WF2, and the third wafer WF3 may be bonded together by a bonding method. The bonded wafers WF1, WF2 and WF3 may be cut into a plurality of chips, and each chip corresponds to a semiconductor device 5000 including stacked semiconductor dies SD1, SD2 and SD3. A cut portion of the first wafer WF1 corresponds to the first semiconductor die SD1, a cut portion of the second wafer WF2 corresponds to the second semiconductor die SD2, and a cut portion of the third wafer WF3 corresponds to the third semiconductor die SD3. The nonvolatile memory device 5000 of FIG. 28 may be manufactured according to the manufacturing process of FIG. 29.

FIG. 30 is a cross-sectional diagram illustrating an example of a semiconductor package including a nonvolatile memory device.

Referring to FIG. 30, in a semiconductor package 2000, a package substrate 2100 may be a printed circuit board. The package substrate 2100 may include a body portion 2120, a package top pad disposed on a top surface of the body portion 2120, a package bottom pad 2125 disposed on a bottom surface of the body portion 2120 or exposed through the bottom surface, and internal wiring 2135 electrically connecting the package top pad to the package bottom pad 2125 within the body portion 2120.

The plurality of lower pads 2125 may be connected to a plurality of wiring patterns on the main substrate via a plurality of conductive bumps 2800.

The package substrate 2100 may be disposed on a stacked structure 2200 including a peripheral circuit semiconductor chip 2010 and a plurality of memory semiconductor chips 2021, 2022, 2023 and 2024. The peripheral circuit semiconductor chip 2010 may be disposed with the peripheral circuit region PREG described above, and each of the plurality of memory semiconductor chips 2021, 2022, 2023 and 2024 may be disposed with a cell region. A molding layer 2500 may be formed to cover the stacked structure 2200 and the package substrate 2100.

The peripheral circuit semiconductor chip 2010 may be disposed with a page buffer circuit and a page buffer decoder as described above. The buffer decoder may perform an integrated column repair that shares redundant bitlines for at least two of the plurality of memory semiconductor chips 2021, 2022, 2023 and 2024.

As described above, a nonvolatile memory device may provide improved repair performance and yield by performing column repair with integrating defective bitlines that occur among a plurality of cell regions. The nonvolatile memory device may reduce repair resources and the size of the nonvolatile memory device.

The memory devices described herein may be applied to any electronic devices and systems including a nonvolatile memory device. For example, the disclosed memory devices may be included in systems such as a memory card, a solid state drive (SSD), an embedded multimedia card (eMMC), a universal flash storage (UFS), a mobile phone, a smart phone, a personal digital assistant (PDA), a portable multimedia player (PMP), a digital camera, a camcorder, a personal computer (PC), a server computer, a workstation, a laptop computer, a digital TV, a set-top box, a portable game console, a navigation system, a wearable device, an internet of things (IoT) device, an internet of everything (IoE) device, an e-book, a virtual reality (VR) device, an augmented reality (AR) device, a server system, a data center, an automotive driving system, etc.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

The foregoing is illustrative of various examples. Although these examples have been described, those skilled in the art will readily appreciate that many modifications are possible without materially departing from the scope of the present disclosure.

Embodiments are set out in the following clauses:
Clause 1. A nonvolatile memory device comprising:
   a first cell region including a plurality of first normal bitlines and a plurality of first redundant bitlines;
   a second cell region including a plurality of second normal bitlines and a plurality of second redundant bitlines; and
   a peripheral circuit region including a page buffer circuit and a page buffer decoder,
   wherein the page buffer circuit includes a plurality of page buffers connected to the plurality of first normal bitlines, the plurality of second normal bitlines, the plurality of first redundant bitlines and the plurality of second redundant bitlines, and
   wherein the page buffer decoder is configured to integrate defective bitlines of the plurality of first normal bitlines and the plurality of second normal bitlines and replace the defective bitlines with redundant bitlines of the plurality of first redundant bitlines and the plurality of second redundant bitlines.
Clause 2. The nonvolatile memory device of clause 1, wherein the second cell region is disposed in above the first cell region in a vertical direction.
Clause 3. The nonvolatile memory device of clause 1 or clause 2, wherein the first cell region and the second cell region are disposed above the peripheral circuit region in a vertical direction,
   wherein the plurality of first normal bitlines, the plurality of first redundant bitlines, the plurality of second normal bitlines, and the plurality of second redundant bitlines are spaced apart in a first horizontal direction and extend in a second horizontal direction perpendicular to the first horizontal direction, and
   wherein the first cell region and the second cell region are spaced apart in the second horizontal direction.

## Claims

1. A nonvolatile memory device (300) comprising:
a first cell region (CREG1) including a plurality of first normal bitlines (NBLL) and a plurality of first redundant bitlines (RBLL);
a second cell region (CREG2) disposed above the first cell region (CREG1) in a vertical direction (D3) and including a plurality of second normal bitlines (NBLU) and a plurality of second redundant bitlines (RBLU); and
a peripheral circuit region (PREG) disposed below the first cell region (CREG1) in the vertical direction (D3) and including a page buffer circuit (PGBF) and a page buffer decoder (PBD),
wherein the page buffer circuit (PGBF) includes a plurality of page buffers (PGBFL, PGBFU) connected to the plurality of first normal bitlines (NBLL), the plurality of second normal bitlines (NBLU), the plurality of first redundant bitlines (RBLL) and the plurality of second redundant bitlines (RBLU),
wherein the page buffer decoder (PBD) is configured to integrate defective bitlines (BL, BU) of the plurality of first normal bitlines (NBLL) and the plurality of second normal bitlines (NBLU) and replace the defective bitlines (BL, BU) with redundant bitlines of the plurality of first redundant bitlines (RBLL) and the plurality of second redundant bitlines (RBLU).

2. The nonvolatile memory device (300) of claim 1, wherein the page buffer decoder (PBD) is configured to perform at least one of: (i) replacing a defective bitline of the plurality of first normal bitlines (NBLL) with a redundant bitline of the plurality of second redundant bitlines (RBLU), or (ii) replacing a defective bitline of the plurality of second normal bitlines (NBLU) with a redundant bitline of the plurality of first redundant bitlines (RBLL).

3. The nonvolatile memory device (300) of claim 1 or claim 2, wherein the page buffer decoder (PBD) includes:
a first switch circuit (SW1) configured to control connections between an input-output line (WOR) and page buffers (PGBFL) connected to the plurality of first normal bitlines (NBLL), based on first column repair information (CRI1) corresponding to one or more defective bitlines (BL) of the plurality of first normal bitlines (NBLL);
a second switch circuit (SW2) configured to control connections between the input-output line (WOR) and page buffers (PGBFU) connected to the plurality of second normal bitlines (NBLU), based on second column repair information (CRI2) corresponding to one or more defective bitlines (BU) of the plurality of second normal bitlines (NBLU); and
a third switch circuit (SW3) configured to control connections between (i) the input-output line (WOR) and (ii) the plurality of first redundant bitlines (RBLL) and the plurality of second redundant bitlines (RBLU), based on the first column repair information (CRI1) corresponding to the one or more defective bitlines (BL) of the plurality of first normal bitlines (NBLL) and the second column repair information (CRI2) corresponding to the one or more defective bitlines (BU) of the plurality of second normal bitlines (NBLU).

4. The nonvolatile memory device (300) of any preceding claim, wherein the first cell region (CREG1) includes a plurality of first wordlines (WLL1, WLL2, WLL3), the second cell region (CREG2) includes a plurality of second wordlines (WLU1, WLU2, WLU3), and the peripheral circuit region (PREG) includes circuitry configured to simultaneously enable:
a first selected wordline corresponding to a row address (R_ADDR) of the plurality of first wordlines (WLL1, WLL2, WLL3) and,
a second selected wordline corresponding to the row address (R_ADDR) of the plurality of second wordlines (WLU1, WLU2, WLU3).

5. The nonvolatile memory device (300) of claim 4, wherein the plurality of first wordlines (WLL1, WLL2, WLL3) and the plurality of second wordlines (WLU1, WLU2, WLU3) are respectively connected to each other through conduction paths (VPH1, VPH2, VPH3).

6. The nonvolatile memory device (300) of claim 4 or claim 5, wherein the peripheral circuit region (PREG) includes circuitry configured to apply a plurality of wordline drive signals (S0 to S63) commonly to the plurality of first wordlines (WLL1, WLL2, WLL3) and the plurality of second wordlines (WLU1, WLU2, WLU3).

7. The nonvolatile memory device (300) of any preceding claim, wherein a sum of a number of the plurality of first normal bitlines (NBLL) and a number of the plurality of second normal bitlines (NBLU) is equal to a bit number of a page that is a unit of a read operation and a write operation.

8. The nonvolatile memory device (300) of any preceding claim, wherein the plurality of first normal bitlines (NBLL), the plurality of first redundant bitlines (RBLL), the plurality of second normal bitlines (NBLU), and the plurality of second redundant bitlines (RBLU) are spaced apart in a first horizontal direction (D1) and extend in a second horizontal direction (D2) perpendicular to the first horizontal direction (D1),
wherein the page buffer decoder (PBD) extends in the first horizontal direction (D1),
wherein page buffers (PGBFL) connected to the first normal bitlines (NBLL) and the first redundant bitlines (RBLL) are arranged adjacent to a first side, in the second horizontal direction (D2), of the page buffer decoder (PBD), and
wherein page buffers (PGBFU) connected to the second normal bitlines (NBLU) and the second redundant bitlines (RBLU) are arranged adjacent to a second side, in the second horizontal direction (D2), of the page buffer decoder (PBD), the second side being opposite to the first side.

9. The nonvolatile memory device (300) of any preceding claim, wherein bitlines (BL) of the first cell region (CREG1) are grouped into a first bitline group (BG1) including a first portion of the plurality of first normal bitlines (NBLL) and a first portion of the plurality of first redundant bitlines (RBLL), and a second bitline group (BG2) including a second portion of the plurality of first normal bitlines (NBLL) and a second portion of the plurality of first redundant bitlines (RBLL), and
wherein bitlines (BU) of the second cell region (CREG2) are grouped into a third bitline group (BG3) including a first portion of the plurality of second normal bitlines (NBLU) and a first portion of the plurality of second redundant bitlines (RBLU), and a fourth bitline group (BG4) including a second portion of the plurality of second normal bitlines (NBLU) and a second portion of the plurality of second redundant bitlines (RBLU).

10. The nonvolatile memory device (300) of claim 9, wherein the page buffer decoder (PBD) includes:
a first page buffer decoder (PGD1) configured to control page buffers connected to first normal bitlines (NBLL) and first redundant bitlines (RBLL) of the first bitline group (BG1) and second normal bitlines (NBLU) and second redundant bitlines (RBLU) of the third bitline group (BG3); and
a second page buffer decoder (PGD2) configured to control page buffers connected to first normal bitlines (NBLL) and first redundant bitlines (RBLL) of the second bitline group (BG2) and second normal bitlines (NBLU) and second redundant bitlines (RBLU) of the fourth bitline group (BG4).

11. The nonvolatile memory device (300) of claim 10, wherein the first page buffer decoder (PBD1) is configured to integrate first defective bitlines of the first normal bitlines (NBLL) of the first bitline group (BG1) and the second normal bitlines (NBLU) of the third bitline group (BG3) and replace the first defective bitlines (BL) with the first redundant bitlines (RBLL) of the first bitline group (BG1) and the second redundant bitlines (RBLU) of the third bitline group (BG3), and
wherein the second page buffer decoder (PBD2) is configured to integrate second defective bitlines (BU) of the first normal bitlines of the second bitline group (BG2) and the second normal bitlines (NBLU) of the fourth bitline group (BG4) and replace the second defective bitlines with the first redundant bitlines (RBLL) of the second bitline group (BG2) and the second redundant bitlines (RBLU) of the fourth bitline group (BG4).

12. The nonvolatile memory device (300) of claim 10 or claim 11, wherein the first page buffer decoder (PBD1) is configured to perform at least one of: (i) replacing defective bitlines of the first normal bitlines (NBLL) of the first bitline group (BG1) with the first redundant bitlines (RBLL) of the first bitline group (BG1) and the second redundant bitlines (RBLU) of the third bitline group (BG3), or (ii) replacing defective bitlines of the second normal bitlines (NBLU) of the third bitline group (BG3) with the first redundant bitlines (RBLL) of the first bitline group (BG1) and the second redundant bitlines (RBLU) of the third bitline group (BG3), and
wherein the second page buffer decoder (PBD2) is configured to perform at least one of: (i) replacing defective bitlines of the first normal bitlines (NBLU) of the second bitline group (BG2) with the first redundant bitlines (RBLL) of the second bitline group (BG2) and the second redundant bitlines (RBLU)of the fourth bitline group (BG4), or (ii) replacing defective bitlines of the second normal bitlines (NBLU) of the fourth bitline group (BG4) with the first redundant bitlines (RBLL) of the second bitline group (BG2) and the second redundant bitlines (RBLU) of the fourth bitline group (BG4).

13. The nonvolatile memory device (300) of any of claims 10-12, wherein the first page buffer decoder (PBD1) is configured to store integrated information regarding defective bitlines of the first normal bitlines (NBLL) of the first bitline group (BG1) and defective bitlines of the second normal bitlines (NBLU) of the third bitline group (BG3), and
wherein the second page buffer decoder (PBD2) is configured to store integrated information regarding defective bitlines of the first normal bitlines (NBLL) of the second bitline group (BG2) and defective bitlines of the second normal bitlines (NBLU) of the fourth bitline group (BG4).

14. The nonvolatile memory device (300) of any preceding claim, wherein the plurality of first normal bitlines (NBLL) and the plurality of first redundant bitlines (RBLL) are arranged to overlap the plurality of second normal bitlines (NBLU) and the plurality of second redundant bitlines (RBLU) in the vertical direction (D3), and
wherein the plurality of second normal bitlines (NBLU) and the plurality of second redundant bitlines (RBLU) included in the second cell region (CREG2) are connected to page buffers (PGBF) included in the peripheral circuit region (PREG) through vertical conduction paths (IOMC) penetrating the first cell region (CREG1), and
wherein each of the plurality of second normal bitlines (NBLU) and the plurality of second redundant bitlines (RBLU) is cut into two segments (BLS1, BLS2) in an intersection region (CSR) through which a corresponding vertical conduction path (IOMC) passes, and the two segments (BLS1, BLS2) are connected to each other through a detour conduction path (DPH) spaced apart from the vertical conduction path (IOMC).

15. The nonvolatile memory device (300) of any preceding claim,
wherein the plurality of first normal bitlines (NBLL) and the plurality of first redundant bitlines (RBLL) included in the first cell region (CREG1) are disconnected from the plurality of second normal bitlines (NBLU) and the plurality of second redundant bitlines (RBLU) included in the second cell region (CREG2).
